# EUROPÄISCHE PATENTSCHRIFT

(11) **EP 4 107 776 B1**
(45) Veröffentlichungstag und Bekanntmachung des Hinweises auf die Patenterteilung: **03.04.2024**
(21) Anmeldenummer: 21707218.0
(22) Anmeldetag: 19.02.2021
(51) Int. Cl.: H01L 21/67, H01L 21/683, B31D 1/02, B65C 9/18

(54) **VORRICHTUNG UND VERFAHREN ZUM ÜBERTRAGEN ELEKTRONISCHER BAUTEILE VON EINEM ERSTEN ZU EINEM ZWEITEN TRÄGER**
APPARATUS AND METHOD FOR TRANSFERRING ELECTRONIC COMPONENTS FROM A FIRST TO A SECOND CARRIER
DISPOSITIF ET PROCÉDÉ DE TRANSFERT DE COMPOSANTS ÉLECTRONIQUES D'UN PREMIER À UN SECOND SUPPORT

(30) Priorität: 21.02.2020 DE 102020001439
(43) Veröffentlichungstag der Anmeldung: 28.12.2022
(73) Patentinhaber: Muehlbauer GmbH & Co. KG, 93426 Roding (DE)
(72) Erfinder: FREIMUTH, Marcel, 94256 Drachselried (DE)
(74) Vertreter: Schmidt, Steffen J.
(86) Internationale Anmeldenummer: PCT/EP2021/054115
(87) Internationale Veröffentlichungsnummer: WO 2021/165450

(56) Entgegenhaltungen:
- WO-A1-2017/076989
- DE-A1-102009 020 540
- DE-A1-102013 010 447
- DE-B3- 10 349 847
- DE-C1- 10 120 269
- US-A- 3 724 068
- US-A1- 2004 118 512
- US-A1- 2004 154 161

## Beschreibung

### Hintergrund

Hier werden eine Vorrichtung und ein Verfahren zum Übertragen elektronischer Bauteile von einem ersten Träger zu einem zweiten Träger beschrieben. Eine Vorrichtung und ein Verfahren zum Aufbringen von Klebstoff auf den zweiten Träger ist ebenfalls beschrieben. Insbesondere werden eine Vorrichtung und ein Verfahren beschrieben, um ein elektronisches Bauteil von dem ersten Träger zu trennen und direkt auf den zweiten Träger zu übertragen. Der zweite Träger kann zum Beispiel eine oder mehrere elektronischen Teilbaugruppen tragen, auf die jeweils ein elektronisches Bauteil zu übertragen ist.

Beim Übertragen von elektronischen Bauteilen, insbesondere Chips (engl.: "dies") und insbesondere beim Übertragen von vereinzelten elektronischen Bauteilen besteht allgemein das Problem, dass diese leicht beschädigt werden können und daher mit großer Sorgfalt behandelt werden müssen. Zudem sind elektronische Bauteile einer kontinuierlichen Miniaturisierung unterworfen, so dass die Anforderungen hinsichtlich der Genauigkeit beim Übertragen der elektronischen Bauteile kontinuierlich steigen.

Die WO 2017/076989 A1 betrifft ein Verarbeitungssystem und Verfahren zur Verarbeitung eines flexiblen Substrats, zum Beispiel einer Bahn unter Verwendung eines Spanners mit einer entlang einer Transportrichtung des flexiblen Substrats bewegbaren Vakuumplatte mit einem Indexierer, der das flexible Substrat intermittierend zur Verarbeitung bewegt. Die Vakuumplatte ist konfiguriert, um entlang der Transportrichtung bewegt zu werden. Ein Indexierer ist konfiguriert, um intermittierend das flexible Substrat zur Verarbeitung zu bewegen. Eine Steuerung ist konfiguriert, den Spanner und den Indexierer so zu steuern, dass eine Relativgeschwindigkeit zwischen dem Indexierer und der Unterdruckplatte des Spanners unter allen Arbeitsbedingungen oberhalb einer vorgegebenen Schwelle gehalten wird, auch wenn das flexible Substrat angehalten wird. Die Bahn, die in dem Verarbeitungssystem verwendet werden kann, weist eine Anzahl von elektrischen Strukturen auf, die durch einen Abstand voneinander getrennt sind. Bei diesen elektrischen Strukturen kann es sich um jede Art von flexibler Elektronik handeln.

Die DE 10 2011 104 225 B4 betrifft ein Vorrichtung zum Positionieren zu übertragender elektronischer Bauteile relativ zu einer Ausstoßeinrichtung, mit der Ausstoßeinrichtung, die einen Schieber für zumindest ein elektronisches Bauteil und ein den Schieber umgebendes Gehäuse aufweist, wobei das Gehäuse einen ersten lichtdurchlässigen Bereich aufweist. Ein erster Träger stellt die zu übertragenden elektronischen Bauteile bereit. Der erste Träger hat eine der Ausstoßeinrichtung zugewandte erste Seite und eine von der Ausstoßeinrichtung abgewandte zweite Seite. Auf der zweiten Seite ist eine Vielzahl der elektronischen Bauteile vorgesehen. Eine Bilddatenerfassungseinrichtung ist dazu eingerichtet, durch den ersten lichtdurchlässigen Bereich des Gehäuses hindurch Bilddaten einer Region zu erfassen, in der der Schieber mit dem wenigstens einen elektronischen Bauteil zu interagieren eingerichtet ist. Eine Steuerung ist dazu eingerichtet, aus den erfassten Bilddaten Positionsdaten des zu übertragenden elektronischen Bauteils zu ermitteln sowie aufgrund der Positionsdaten Steuerbefehle zu erzeugen. Zumindest ein Aktor ist dazu eingerichtet, den ersten Träger und die Ausstoßeinrichtung aufgrund der Steuerbefehle relativ zueinander zu bewegen, um einen Versatz zwischen einer Längsachse des Schiebers und einer Mittelachse des zu übertragenden elektronischen Bauteils zu verändern, wobei die Ausstoßeinrichtung einen im Inneren des Gehäuses angeordneten ersten Spiegel umfasst.

Die DE 103 49 847 B3 betrifft eine Positioniervorrichtung und ein Positionierverfahren für die Übertragung elektronischer Bauteile beschrieben. Dabei ist ein auf einer Trägerfolie angeordneter Halbleiter-Wafer oberhalb und parallel zu einem bandartigen Substrat angeordnet. Der Wafer kann mittels einer Waferhalterung innerhalb der Waferebene verschoben und zusätzlich um eine senkrecht zu der Waferebene stehende Rotationsachse gedreht werden. Eine Ausstoßeinrichtung umfasst eine Ausstechnadel, die mittels einer Bewegung nach unten auf die Rückseite eines abzulösenden Chips wirkt und diesen von der Trägerfolie ablöst. Der von der Trägerfolie abgelöste Chip wird dadurch auf eine Bondposition auf dem bandartigen Substrat abgelegt.

Die JP 2003 109979 A betrifft eine Vorrichtung mit zumindest zwei Schiebern zum Heraustrennen von Bauteilen aus einem ersten Träger. Dabei werden die Bauteile jeweils von einer Saug-Pipette eines Übertragungselements aufgenommen. In einem letzten Schritt wird das Übertragungselement samt Saug-Pipetten und Bauteilen über einen zweiten Träger positioniert, welcher bereits mit Haftmittel präpariert wurde, und die Bauteile auf den zweiten Träger abgelegt. Dabei werden die Bauteile nicht direkt vom ersten Träger zum zweiten Träger übertragen, sondern nach der Abtrennung vom ersten Träger mittels eines Übertragungselements aufgenommen, und in einem Folgeschritt durch das Übertragungselement genau orientiert und auf den zweiten Träger befestigt.

Die DE 10 2018 006 771 A1 betrifft eine Lösung zur Steigerung des Durchsatzes beim Übertragen der Bauteile von dem ersten auf den zweiten Träger mit einer hohen Genauigkeit und Wiederholbarkeit, wobei auch wenig bis gar nicht transparente zweite Träger ohne Qualitätseinbußen bei der Lage-Genauigkeit der Bauteil-Ablage verwendbar sein. Hierzu dient eine Vorrichtung zum Übertragen elektronischer Bauteile von einem ersten Träger zu einem zweiten Träger, wobei der erste Träger eine Vielzahl vereinzelter Bauteile von ihm lösbar trägt, und der zweite Träger quasi-endlos ausgestaltet ist und in seiner Längs- und Quererstreckung eine Vielzahl elektronischer Teilbaugruppen trägt, zu denen jeweils eines der Bauteile von dem ersten Träger zu übertragen ist. Die Vorrichtung umfasst eine erste Aufnahme, die dazu eingerichtet ist, den ersten Träger aufzunehmen; eine zweite Aufnahme, die dazu eingerichtet ist, dass über sie der zweite Träger entlang seiner Längserstreckung in einer Förderrichtung des zweiten Trägers zu führen ist; wobei die erste Aufnahme dazu eingerichtet ist, den ersten Träger so aufzunehmen, dass die von ihm getragenen Bauteile zu der zweiten Aufnahme hin orientiert sind; eine Trenneinrichtung, die dazu eingerichtet ist, die Bauteile von dem ersten Träger berührend oder berührungslos abzutrennen, um sie auf den zweiten Träger zu übertragen; eine erste Fördereinrichtung, die dazu vorgesehen und eingerichtet ist, die erste Aufnahme quer zur Förderrichtung des zweiten Trägers relativ zu der zweiten Aufnahme zu bewegen; eine zweite Fördereinrichtung, die dazu vorgesehen und eingerichtet ist, die Trenneinrichtung quer zur Förderrichtung des zweiten Trägers relativ zu der zweiten Aufnahme zu bewegen; eine erste Inspektionseinrichtung , die dazu vorgesehen und eingerichtet ist, wenigstens eines der Bauteile in seiner Lage relativ zu einer Ablageposition auf der den zweiten Träger führenden zweiten Aufnahme zu erfassen; eine zweite Inspektionseinrichtung, die aufstromseitig zur Ablageposition angeordnet und dazu vorgesehen und eingerichtet ist, wenigstens eine der Vielzahl elektronischer Teilbaugruppen auf dem zweiten Träger in ihrer Lage relativ zu der zweiten Aufnahme zu erfassen und eine die erfasste Lage repräsentierende Information an eine Steuerung zu signalisieren; eine dritte Fördereinrichtung, die dazu vorgesehen und eingerichtet ist, in Ansprache auf von der Steuerung signalisierte Information, den zweiten Träger in seiner Lage relativ zu der Ablageposition so zu fördern, dass die wenigstens eine der Vielzahl elektronischer Teilbaugruppen auf dem zweiten Träger zu der Ablageposition auf der den zweiten Träger führenden zweiten Aufnahme gelangt.

Weitere Vorrichtungen und Verfahren zum Übertragen von elektronischen Bauteilen, die technologischen Hintergrund zur hier beschrieben Vorrichtung und zum hier beschriebenen Verfahren bilden, werden in JP 5267451 A, EP 0 565 781 B1 und DE 198 22 512 A1, US 4,667,402 B1, US 2008/0086874 A1, EP 1 764 826 A1, US 2002/019074 A1, US 2009/ 242124 A1, EP 0 140 126 A1, US 4,990,051 B1, US 2006/237142 A1, US 2007/293022 A1, US 6,201,306 B1, JP 2009 238881 A, JP 2010 161155 A, JP 60 097634 A, JP 01 109737 A, JP 55 070041 A, JP 2002 050670 A, JP 09 162204 A, JP 53 100765 A, JP 2008 004936 A, WO 2007/137888 A1, WO 2000/014789 A1, EP 949 662 A2, US 2006/013680 A1, US 2016/308269 A1, DE 10 2011 017 218 A1, EP 2 491 583 B1 DE 10 2009 020 540 A1 und DE 10 2013 010 447-A1 beschrieben.

### Problem

Vor diesem Hintergrund sind eine Anordnung und eine Vorgehensweise erwünscht, mit der der Durchsatz beim Übertragen der Bauteile von dem ersten auf den zweiten Träger mit einer hohen Genauigkeit und Wiederholbarkeit zu steigern ist. Außerdem sollen auch wenig bis gar nicht transparente zweite Träger ohne Qualitätseinbußen bei der Lage-Genauigkeit der Bauteil-Ablage verwendbar sein. Schließlich sollen die Bauteile schonend behandelt werden.

### Vorgeschlagene Lösung

Zur Lösung dieser Aufgabe wird eine Vorrichtung zum Übertragen elektronischer Bauteile von einem ersten Träger zu einem zweiten Träger vorgeschlagen, die zum Übertragen elektronischer Bauteile, zum Beispiel RFID-Chips, von einem ersten Träger, zum Beispiel einer Waferträgerfolie, zu einem zweiten Träger, zum Beispiel einem quasi-endlos ausgestalteten (Antennen-)Trägerbandmaterial, das in seiner Quer- und/oder Längserstreckung eine Vielzahl elektronischer Teilbaugruppen, zum Beispiel Antennen, trägt. Dabei trägt in einer Variante der erste Träger eine Vielzahl vereinzelter Bauteile, zum Beispiel RFID-Chips, von ihm lösbar. Auf den zweiten Träger, das (Antennen-)Trägerbandmaterial, ist jeweils eines der Bauteile (RFID-Chips) von dem ersten Träger (Waferträgerfolie) zu übertragen.

Die Vorrichtung ist dazu ausgestaltet, den ersten Träger mit einer ersten Aufnahme aufzunehmen; den zweiten Träger entlang seiner Längserstreckung in einer Förderrichtung des zweiten Trägers mit einer zweiten Aufnahme führen; mit der ersten Aufnahme den ersten Träger so aufnehmen, dass die von ihm getragenen Bauteile zu der zweiten Aufnahme hin orientiert sind, die Bauteile in Ansprache auf von einer Steuerung signalisierte Information von dem ersten Träger mit einer Trenneinrichtung berührend oder berührungslos abtrennen, um sie auf den zweiten Träger zu übertragen; den zweiten Träger in Ansprache auf von der Steuerung signalisierte Information in seiner Lage relativ zu der Ablageposition mit einer Fördereinrichtung so zu fördern, dass eine elektronische Teilbaugruppe auf dem zweiten Träger zu der Ablageposition auf der den zweiten Träger führenden zweiten Aufnahme gelangt; wobei die zweite Aufnahme eine in der Förderrichtung des zweiten Trägers gekrümmte Anlage für den zweiten Träger aufweist.

Der zweiten Aufnahme ist in einer Variante als Fördereinrichtung ein Antrieb zugeordnet, der quer zu der Förderrichtung des zweiten Trägers nur einen Teil der zweiten Aufnahme einnimmt. Die Fördereinrichtung kann dazu vorgesehen und eingerichtet sein, in Ansprache auf von einer Steuerung signalisierte Information, den zweiten Träger in seiner Lage relativ zu der Ablageposition so zu fördern, dass eine elektronische Teilbaugruppe auf dem zweiten Träger zu der Ablageposition auf der den zweiten Träger führenden zweiten Aufnahme gelangt. Im Bereich der zweiten Aufnahme ist eine Heizung dazu vorgesehen und eingerichtet, auf den zweiten Träger zu wirken, um diesen vor, an, und/oder nach der Ablageposition von seiner von der ersten Aufnahme abliegenden Seite her zu temperieren.

Insbesondere dient die Vorrichtung zum Übertragen elektronischer Bauteile von einem ersten Träger zu einem zweiten Träger. Dabei trägt der erste Träger eine Vielzahl vereinzelter Bauteile von ihm lösbar. Der zweite Träger ist quasi-endlos gestaltet und trägt in seiner Längserstreckung eine Vielzahl elektronischer Teilbaugruppen, zu denen jeweils eines der Bauteile von dem ersten Träger zu übertragen ist. Die Vorrichtung umfasst eine erste Aufnahme, die dazu vorgesehen und eingerichtet ist, den ersten Träger aufzunehmen. Die Vorrichtung umfasst eine zweite Aufnahme, die dazu vorgesehen und eingerichtet ist, den zweiten Träger entlang seiner Längserstreckung in einer Förderrichtung des zweiten Trägers zu führen. Dabei ist die erste Aufnahme dazu vorgesehen und eingerichtet, den ersten Träger so aufzunehmen, dass die von ihm getragenen Bauteile zu der zweiten Aufnahme hin orientiert sind.

Eine Trenneinrichtung ist dazu vorgesehen und eingerichtet, die Bauteile von dem ersten Träger berührend oder berührungslos abzutrennen, um sie auf den zweiten Träger zu übertragen. Eine erste Fördereinrichtung ist dazu vorgesehen und eingerichtet, die erste Aufnahme relativ zu der zweiten Aufnahme zu bewegen.

Eine Fördereinrichtung ist dazu vorgesehen und eingerichtet, in Ansprache auf von einer Steuerung signalisierte Information, den zweiten Träger in seiner Lage relativ zu der Ablageposition so zu fördern, dass eine elektronische Teilbaugruppe auf dem zweiten Träger zu der Ablageposition auf der den zweiten Träger führenden zweiten Aufnahme gelangt. Die zweite Aufnahme weist eine in der Förderrichtung des zweiten Trägers gekrümmte Anlagefläche für den zweiten Träger auf.

Eine im Bereich der zweiten Aufnahme wirkende Heizung ist dazu vorgesehen und eingerichtet, den zweiten Träger vor, an, und/oder nach der Ablageposition von seiner von der ersten Aufnahme abliegenden Seite her zu temperieren.

Die zweite Aufnahme umfasst eine Fördereinrichtung zumindest teilweise, die quer zu der Förderrichtung des zweiten Trägers nur einen Teil der zweiten Aufnahme einnimmt.

In einer weiteren Variante ist die zweite Aufnahme als kreiszylindrische Trommel ausgestaltet und kann als Ganzes mit einer Heizung beheizbar sein. Diese beheizbare Trommel ist in einer Variante durch eine einen Antrieb umfassende Fördereinrichtung drehbar, die den zweiten Träger in Förderrichtung hin zu / weg von der Ablageposition des Bauteils transportiert.

Anstelle einer kreiszylindrischen Trommel kann die zweite Aufnahme auch als zur ersten Aufnahme hin konvex gebogene oder gekrümmte Fläche gestaltet sein, die ortsfest angeordnet ist und der die weitere, dritte Fördereinrichtung für den zweiten Träger räumlich und/oder funktionell zugeordnet ist.

### Vorteile und Funktionsweise

Bisher wird für die Bestückung von Teilbaugruppen oder Anschlussrahmen mittels Direktablage (DDA = direkt die attach) in der Regel einreihiges Bandmaterial als zweiten Träger verwendet, auf dem die Bauteile aus dem ersten Träger abgelegt werden. Die vorgestellte Lösung erlaubt, einreihiges Bandmaterial als zweiten Träger zu verwenden. Dadurch werden die verringerte Komplexität und der höhere Durchsatz der Direktablage-Anordnung auf den Bereich von Anlagen übertragen, die in der Lage sind, einreihiges Bahnmaterial verarbeiten. Die hier vorgeschlagene Lösung erlaubt auch, die bisherige Inspektion des zweiten Trägers an der Ablageposition zu ersetzen. Somit können auch wenig bis gar nicht transparente zweite Träger ohne Genauigkeitseinbußen bei der Bauteil-Ablage verwendet werden, um ein Bauteil mit der Teilbaugruppe passgenau zusammen zu bringen.

Herkömmliche DDA Anlagen für einreihiges Bahnmaterial nutzen zur Erkennung der Ablageposition auf dem Bahnmaterial vor Bauteilablage eine Kamera, die direkt im Ablagebereich auf der Rück-/)Unterseite des Bahnmaterials des zweiten Trägers angebracht ist. Durch diese Anordnung können herkömmliche DDA Anlagen nur volltransparente Materialien, z. B. PET, ohne Einschränkung der Ablage-Genauigkeit verarbeiten, intransparente Materialien als zweiter Träger sind generell nicht möglich.

Die vorgeschlagene Lösung erfasst die Ablageposition auf dem Bahnmaterial (räumlich / zeitlich) vor der eigentlichen Bauteil-Ablage, wobei die zweite Bilderfassungseinrichtung direkt, also nicht durch den zweiten Träger hindurch, sondern die jeweilige Bauteil-Ablagestelle auf dem zweiten Träger selbst erfasst. Dann wird der zweite Träger so kontrolliert zu der Ablageposition gefördert, dass die Bauteil-Ablagestelle möglichst präzise mit der Position des abzulegenden Bauteils an dem ersten Träger fluchtet, wenn die Trenneinrichtung dieses Bauteil von dem ersten Träger trennt und dieses dann in Z-Richtung auf den zweiten Träger übertragen wird.

Im Vergleich zu pick-and-place Anlagen oder zu flip-chip Anlagen ist mit der vorgeschlagenen Lösung wegen ihrer strukturell niedrigeren Komplexität ein signifikant höherer Durchsatz der Bauteile erzielbar. Dabei können die Bauteile direkt einzeln aus dem (zersägten) Wafer getrennt werden und in jeweilige Teilbaugruppe (oder Anschlussrahmen oder dergl.) auf dem zweiten Träger platziert werden; ein Zwischenträger wie bei herkömmlichen Bestückautomaten ist nicht mehr erforderlich. Die Transparenz des Materials des zweiten Trägers hat keinen Einfluss mehr auf die Lage-Genauigkeit beim Ablegen des Bauteils.

So erlaubt die hier vorgestellte Vorrichtung, zum Beispiel RFID-Inlays oder RFID-Module herzustellen, bei denen der elektrische Kontakt zwischen dem RFID-Chip und der Antenne durch Verlöten hergestellt wird. Dafür besteht die Antenne aus einem elektrisch leitenden Material, das unter entsprechender Temperatureinwirkung aufschmilzt. In diesem aufgeschmolzenen Zustand wird der RFID-Chip mit seinen Kontakten (bumps) in die geschmolzenen freiliegenden Enden der Antenne abgelegt. So verbinden sich die Kontakte des RFID-Chips dauerhaft und ausreichend elektrisch und mechanisch mit den Kontaktstellen der Antenne.

So ist die elektrische und mechanische Verbindung bereits bei der Ablage des Bauteils auf das Trägermaterial(-Band) herzustellen, genauer gesagt, auf die Antennen, welche auf dem Trägermaterial(-Band) aufgebracht sind. Dazu wird das Trägermaterial(-Band) zum Zeitpunkt der Ablage auf eine Temperatur gebracht, bei dem das Lot / Material der Antenne zumindest im Bereich den freiliegenden Enden der Antenne und auf seine Schmelztemperatur gebracht wird, und die Kontakte des RFID-Chips damit in Berührung gebracht werden.

Diese Vorgehensweise erlaubt, auf den bei der herkömmlichen Herstellung von RFID-Inlays verwendeten leitfähigen Klebstoff (ACA) zwischen den freiliegenden Enden der Antenne und den Kontakten des RFID-Chips zu verzichten.

Sofern ein Klebstoff zur Verbindung des RFID-Chips mit der Antenne verwendet wird, muss dieser lediglich die mechanische Verbindung gewährleisten. Hierfür reichen preiswerte, nicht mit elektrischem Leitermaterial gefüllte Klebstoffe oder Heißschmelzkleber aus. Dieser nicht leitfähige Klebstoff kann in einer Variante bereits auf dem Trägermaterial-(Band) zumindest im Bereich der freiliegenden Enden der Antenne aufgebracht sein. Beim Temperieren des Trägermaterial-(Bands) werden das Lot / Material der Antenne sowie der nicht leitfähige Klebstoff auf seine Schmelztemperatur gebracht, wodurch eine Spendeeinrichtung für Klebstoff in einer Variante auch entfallen kann.

Des Weiteren kann bei einigen Varianten ein sonst übliches Finalbondmodul der Prozesskette entfallen. Dies verringert die Komplexität, die Größe und die Kosten der Maschine deutlich.

Mit der vorgestellten Vorrichtung und dem Verfahren wird das Trägermaterial(-Band), auf dem z.B. Antennen aufgebracht sind, auf seinem Weg zu der Ablageposition, an der Ablageposition, und/oder auf dem Weg von der Ablageposition durch wenigstens ein entsprechendes Heizelement erwärmt. Diese/s Heizelement/e wirkt/en an der von der Teilbaugruppe (z.B. Antenne) abliegenden Seite auf das das Trägermaterial(-Band) ein, so dass zumindest das Lot / Material der freiliegenden Enden der Antenne auf seine Schmelztemperatur gebracht wird. Durch Abgeben des Bauteils von dem ersten Träger werden die Kontakte des RFID-Chips mit den freiliegenden Enden der Antenne in Berührung gebracht. Nach dem (kontrollierten) Abkühlen des Lots / Materials der freiliegenden Enden der Antenne unter die Schmelztemperatur ist das Bauteil (der RFID-Chip) elektrisch und mechanisch mit der Teilbaugruppe (Antenne) verbunden.

In einer Variante der Vorrichtung hat die gekrümmte Anlagefläche und/oder die Fördereinrichtung mit einer Unterdruckquelle zu verbindende Öffnungen. Diese sind dazu vorgesehen und eingerichtet, den zweiten Träger in eine enge Anlage an die gekrümmte Anlagefläche zu bringen. Bei dem Transport des zweiten Trägers wird durch die unter Unterdruck gesetzten Öffnungen, beispielsweise Vakuumbohrungen, der zweiten Träger schlupffrei fixiert, was dessen kontrollierten Transport und passgenaue Ablage des Bauteils relativ zu der Teilbaugruppe ermöglicht.

In einer Variante der Vorrichtung ist die gekrümmte Anlagefläche starr. Des Weiteren unterteilt die Fördereinrichtung die gekrümmte Anlage entlang der Förderrichtung des zweiten Trägers in wenigstens zwei Abschnitte.

In einer weiteren Variante der Vorrichtung ist eine Wärme-Abschirmung in Förderrichtung des zweiten Trägers gesehen vor und/oder nach der Ablageposition angeordnet. Alternativ oder kumulativ dazu ist zwischen der gekrümmten Anlagefläche und der Wärme-Abschirmung ein Spalt für den zweiten Träger angeordnet. Auf diese Weise wird erreicht, dass die Heizeinrichtung den ersten Träger und eine zwischen den Bauteilen und dem ersten Träger befindliche Haftschicht nicht oder möglichst wenig aufheizt.

In einer weiteren Variante ist der Vorrichtung aufstrom- und/oder abstromseitig der Ablageposition oder der gekrümmten Anlagefläche ein Pufferspeicher zugeordnet, der dazu vorgesehen und eingerichtet ist, einen Vorrat des zweiten Trägers aufzunehmen. Dieser Pufferspeicher ist in einer Variante als zur Ablageposition hin offener Kasten gestaltet, der den zweiten Träger ggf. mit Unterdruck hält oder verzögert führt.

In einer weiteren Variante ist eine erste Bilderfassungseinrichtung dazu vorgesehen und eingerichtet, im Bereich der Ablageposition einen Bildeinzug zumindest eines an dem ersten Träger befindlichen Bauteils vorzunehmen und der Steuerung zu signalisieren. In einer weiteren Variante ist eine zweite und/oder eine dritte Bilderfassungseinrichtung angeordnet, die dazu vorgesehen und eingerichtet ist, im Bereich aufstrom- und/oder abstromseitig der Ablageposition Bildeinzüge von wenigstens einer elektronischen Teilbaugruppe auf dem zweiten Träger ohne / mit dem Bauteil vorzunehmen und der Steuerung zu signalisieren.

In einer weiteren Variante ist ein Abstand zwischen der gekrümmten Anlagefläche mit der Fördereinrichtung und der ersten Aufnahme vorgesehen, der durch eine erste Verstelleinrichtung einstellbar ist.

In einer weiteren Variante ist die gekrümmte Anlagefläche mit der Fördereinrichtung von einer im Wesentlichen U-förmigen Aufnahme gehalten, die von zwei Lagern aufgenommen und im Wesentlichen senkrecht zu der Förderrichtung des zweiten Trägers beweglich geführt ist. Dabei sind ggf. die U-förmige Aufnahme, die gekrümmte Anlagefläche und/oder die wenigstens eine Fördereinrichtung durch eine jeweilige Stelleinrichtung in Ansprache auf von der Steuerung signalisierte Information zu positionieren.

In einer weiteren Variante ist im Bereich aufstrom- und/oder abstromseitig der gekrümmten Anlagefläche oder der Ablageposition jeweils wenigstens ein Niederhalter vorgesehen und eingerichtet, um den zweiten Träger im Bereich der gekrümmten Anlagefläche dem Unterdruck auszusetzen.

In einer weiteren Variante ist im Bereich aufstrom- und/oder abstromseitig und/oder entlang der Quererstreckung der gekrümmten Anlagefläche oder der Ablageposition wenigstens eine Heizzone angeordnet, die dazu vorgesehen und eingerichtet ist, in Ansprache auf von der Steuerung signalisierte Information Wärme abzugeben, wobei im Fall mehrerer Heizzonen diese dazu vorgesehen und eingerichtet sind, in Ansprache auf von der Steuerung signalisierte Information unabhängig voneinander zu Wärme abzugeben.

In einer weiteren Variante sind im Bereich aufstromseitig der Ablageposition eine gekrümmte Anlagefläche und ein Klebstoff-Spender angeordnet, die dazu vorgesehen und eingerichtet sind, zwischen sich den zweiten Träger hindurchzuführen, und in Ansprache auf von der Steuerung signalisierte Information portioniert Klebstoff auf den zweiten Träger abzugeben.

In einer weiteren Variante ist im Bereich aufstrom- und/oder abstromseitig der weiteren gekrümmten Anlagefläche eine vierte und/oder eine fünfte Bilderfassungseinrichtung angeordnet, die dazu vorgesehen und eingerichtet ist, im Bereich aufstrom- und/oder abstromseitig der weiteren gekrümmten Anlagefläche Bildeinzüge von wenigstens einer elektronischen Teilbaugruppe auf dem zweiten Träger ohne / mit dem abgegebenen Klebstoff vorzunehmen und der Steuerung zu signalisieren.

In einer weiteren Variante ist der weiteren gekrümmten Anlagefläche eine zusätzliche Fördereinrichtung zugeordnet, die dazu vorgesehen und eingerichtet ist, den zweiten Träger entlang der weiteren gekrümmten Anlagefläche zu fördern.

In einer weiteren Variante ist der Trenneinrichtung eine Justiereinrichtung zugeordnet, die dazu vorgesehen und eingerichtet ist, die Trenneinrichtung in Förderrichtung des zweiten Trägers und/oder quer dazu zu positionieren. In einer weiteren Variante ist bei der Ablageposition eine erste Bilderfassungseinrichtung angeordnet, und dazu vorgesehen und eingerichtet ist, wenigstens eines der Teilbaugruppen in ihrer Lage relativ zu einer Ablageposition auf der den zweiten Träger führenden zweiten Aufnahme zu erfassen. Ggf. ist eine zweite Bilderfassungseinrichtung angeordnet, und dazu vorgesehen und eingerichtet, die aufstromseitig zur Ablageposition (AP) angeordnet und dazu vorgesehen und eingerichtet, wenigstens eine der elektronischen Teilbaugruppen auf dem zweiten Träger in ihrer Lage relativ zu der zweiten Aufnahme zu erfassen und eine die erfasste Lage repräsentierende Information an eine Steuerung zu signalisieren.

Die der der zweiten Ablage funktional / räumlich zugeordnete Fördereinrichtung ist hier auch als dritte oder weitere Fördereinrichtung für den zweiten Träger bezeichnet.

Ein hier vorgestelltes Verfahren dient zum Übertragen elektronischer Bauteile von einem ersten Träger zu einem zweiten Träger, wobei der erste Träger eine Vielzahl vereinzelter Bauteile von ihm lösbar trägt, und der zweite Träger quasi-endlos ausgestaltet ist und in seiner Längserstreckung eine Vielzahl elektronischer Teilbaugruppen trägt, zu denen jeweils eines der Bauteile von dem ersten Träger zu übertragen ist. Das Verfahren umfasst die folgenden Schritte in der nachstehend angegebenen oder einer anderen Reihenfolge:
den ersten Träger mit einer ersten Aufnahme aufnehmen;
den zweiten Träger entlang seiner Längserstreckung in einer Förderrichtung des zweiten Trägers mit einer zweiten Aufnahme führen;
mit der ersten Aufnahme den ersten Träger so aufnehmen, dass die von ihm getragenen Bauteile zu der zweiten Aufnahme hin orientiert sind;
die Bauteile von dem ersten Träger mit einer Trenneinrichtung berührend oder berührungslos abtrennen, um sie auf den zweiten Träger zu übertragen;
den zweiten Träger in Ansprache auf von einer Steuerung signalisierte Information in seiner Lage relativ zu der Ablageposition mit einer Fördereinrichtung so fördern, dass eine elektronische Teilbaugruppe auf dem zweiten Träger zu der Ablageposition auf der den zweiten Träger führenden zweiten Aufnahme gelangt; und auf den zweiten Träger im Bereich der zweiten Aufnahme mit einer Heizung so einwirken, dass der zweite Träger vor, an, und/oder nach der Ablageposition von seiner von der ersten Aufnahme abliegenden Seite her temperiert wird.

Dieses Temperieren erfolgt - durch entsprechende Ansteuerung der Heizung durch die Steuerung - einheitlich oder in Abschnitten / Zonen im Bereich der zweiten Aufnahme in Abhängigkeit von der Materialbeschaffenheit / dem Schmelzpunkt von Kontaktstellen des zu übertragenden Bauteils und/ oder der Materialbeschaffenheit / dem Schmelzpunkt von Kontaktstellen der Komponenten / der elektronischen Teilbaugruppe auf dem zweiten Träger. So ist eine mechanisch und elektrisch sichere Verbindung zwischen dem zu übertragenden Bauteil und der Komponente / der elektronischen Teilbaugruppe auf dem zweiten Träger auf einfache und schnelle Weise sicherzustellen.

Mit einer oder mehreren der Bilderfassungseinrichtungen wird vor, an, und/oder nach der Ablageposition die Position des zweiten Trägers und der darauf befindlichen Teilbaugruppe für die Ablage des darauf abzulegenden Bauteils ermittelt. Das Ergebnis dieser Bilderfassung (en) wird dann durch die Steuerung, in Kombination mit Positionsdaten der weiteren Fördereinrichtung dazu verwendet, die genaue Position der Teilbaugruppe auf dem zweiten Träger in der Ablageposition zu ermitteln und den ersten Träger mit dem abzulegenden Bauteil entsprechend zu positionieren. Eine der Bilderfassungseinrichtungen inspiziert die Oberseite des zweiten Trägers. Damit ist die Qualität der Bilderfassung unabhängig von der Transparenz des Trägermaterials.

Eine vorzugsweise feststehende, der Kontur der zweiten Aufnahme zumindest teilweise folgende Heizung in Gestalt einer Heizleiste mit einer oder mehreren unterschiedlich zu temperierenden Heizzonen beheizt den zweiten Träger im Bereich der zweiten Aufnahme. So wird der zweite Träger vor, an, und/oder nach der Ablageposition von seiner von der ersten Aufnahme abliegenden Seite her temperiert. Die ggf. mehreren Heizzonen der Heizleiste erlauben die genauere Einstellung des Aufheiz- und Abkühlverhaltens des Materials. Hierzu befindet sich in einer Variante die Heizung in einer Ausnehmung der zweiten Aufnahme. Dabei kann in einer Variante die Heizleiste oder ein Teil davon die zweite Aufnahme geringfügig in Richtung zu der ersten Aufnahme hin überragen. So sind der zweite Träger und die darauf befindlichen Teilbaugruppe(n) gezielt und räumlich / örtlich definiert zu temperieren.

In einer Variante sind zum Beispiel in Querrichtung zwei, drei oder mehr Teilbaugruppen auf dem zweiten Träger angeordnet. Entsprechend sind zwei, drei oder mehr in Querrichtung beabstandete Heizungen als ringförmige Trägerscheiben mit jeweiligen Heizleisten vorgesehen.

Alternativ oder kumulativ zu der hauptsächlich berührend temperierenden Heizung mit der Heizleiste ist eine kontaktlose Erwärmung des zweiten Trägers und der darauf befindlichen Teilbaugruppe(n) durch Laser, Infrarot oder Induktion möglich.

In einer Variante befindet sich die erste Aufnahme mit dem ersten Träger unmittelbar über dem zweiten Träger auf der zweiten Aufnahme. Im Gegensatz zu bisherigen Lösungen haben die erste Aufnahme und die Trenneinrichtung einen der Breite des zweiten Trägers zumindest annähernd entsprechenden Bewegungsraum quer zur Förderrichtung des zweiten Trägers. Dadurch vergrößert sich der Arbeits- /Bauteil-Ablagebereich signifikant über die Breite des zweiten Trägers. Mithin können mehrere nebeneinander liegende Reihen elektronischer Teilbaugruppen, zum Beispiel RFID-Antennen, auf einem breiten zweiten Träger mit dem ersten Träger erreicht und durch Betätigen der Trenneinrichtung an der Ablageposition bestückt werden.

In einer Variante hat der erste Träger eine der Trenneinrichtung zugewandte erste Seite und eine von der Trenneinrichtung abgewandte zweite Seite, die dem zweiten Träger auf/an der zweiten Aufnahme zugewandt ist, wobei auf der zweiten Seite des ersten Trägers die Vielzahl der Bauteile lösbar aufgebracht ist; die erste Bilderfassungseinrichtung ist dazu eingerichtet, Bilddaten einer Region zu erfassen, in der die Trenneinrichtung zum berührenden oder berührungslosen Interagieren mit wenigstens einem der Bauteile eingerichtet ist um dieses von dem ersten Träger zu trennen; und die Steuerung ist dazu eingerichtet, aus den erfassten Bilddaten Positionsdaten des zu übertragenden Bauteils zu ermitteln, sowie aufgrund der Positionsdaten Steuerbefehle für die Trenneinrichtung und die jeweiligen Fördereinrichtungen zu erzeugen.

In einer Variante ist die zweite Bilderfassungseinrichtung - bezogen auf die Förderrichtung des zweiten Trägers - aufstromseitig zur Ablageposition bei dem zweiten Träger angeordnet und dazu vorgesehen und eingerichtet, in Förderrichtung des zweiten Trägers und/oder quer zur Förderrichtung des zweiten Trägers jeweils ein oder mehrere der Vielzahl elektronischer Teilbaugruppen auf dem zweiten Träger in ihrer Lage relativ zu der zweiten Aufnahme zu erfassen und eine die erfasste Lage repräsentierende Information an die Steuerung zu signalisieren.

In einer Variante ist der dritten Fördereinrichtung eine erste Sensoreinrichtung zugeordnet, die dazu vorgesehen und eingerichtet ist, der Steuerung Information zu Förderrichtung, Förderweg des zweiten Trägers und/oder Positionen der auf ihm befindlichen elektronischen Teilbaugruppen der relativ zu der Ablageposition zu signalisieren.

In einer Variante ist die Steuerung dazu vorgesehen und eingerichtet, basierend auf der Information der zweiten Bilderfassungseinrichtung zur Lage der wenigstens einen elektronische Teilbaugruppe und der Information zu Förderrichtung und Förderweg des zweiten Trägers sowie basierend auf der Information der ersten Bilderfassungseinrichtung zur Lage wenigstens eines der Bauteile relativ zur Ablageposition die zweite Fördereinrichtung anzusteuern, um die Trenneinrichtung quer zur Förderrichtung des zweiten Trägers zu der Ablageposition zu bewegen, und die Trenneinrichtung im Sinne eines Trennens des Bauteils von dem ersten Träger zu aktivieren.

In einer Variante umfasst die Vorrichtung eine vierte Fördereinrichtung, die dazu vorgesehen und eingerichtet ist, in Ansprache auf von der Steuerung signalisierte Information, die erste Aufnahme längs der Förderrichtung des zweiten Trägers relativ zu der zweiten Aufnahme zu bewegen; und/oder eine fünfte Fördereinrichtung, die dazu vorgesehen und eingerichtet ist, in Ansprache auf von der Steuerung signalisierte Information, die erste Aufnahme um einen Winkel relativ zu der zweiten Aufnahme zu drehen.

In einer weiteren Variante umfasst die Vorrichtung eine sechste Fördereinrichtung, die dazu vorgesehen und eingerichtet ist, in Ansprache auf von der Steuerung signalisierte Information, den zweiten Träger so (schlupffrei und so dehnungsfrei) entlang der Förderrichtung über die zweite Aufnahme zu fördern, dass die wenigstens eine der Vielzahl elektronischer Teilbaugruppen auf dem zweiten Träger zu der Ablageposition auf der den zweiten Träger führenden zweiten Aufnahme gelangt.

In einer weiteren Variante der Vorrichtung umfasst die Trenneinrichtung, sofern sie dazu eingerichtet ist, die Bauteile von dem ersten Träger berührend abzutrennen, eine Stoßnadel, die dazu eingerichtet und dimensioniert ist, in Ansprache auf von der Steuerung signalisierte Information den ersten Träger zu punktieren, um jeweils eines der Bauteile von dem ersten Träger abzulösen und auf den zweiten Träger zu übertragen; oder sofern sie dazu eingerichtet ist, die Bauteile von dem ersten Träger berührungslos abzutrennen, umfasst die Trenneinrichtung eine steuerbare Energiequelle, die dazu eingerichtet und dimensioniert ist, in Ansprache auf von der Steuerung signalisierte Information den ersten Träger mit Energie zu beschicken, um jeweils eines der Bauteile von dem ersten Träger abzulösen und auf den zweiten Träger zu übertragen.

In einer weiteren Variante der Vorrichtung umfasst die zweite Aufnahme eine (kreis-)zylindrische Trommel oder eine konvex gekrümmte Fläche, über die der zweite Träger zu der Ablageposition auf der zweiten Aufnahme gelangt, wobei in einer Variante die zweite Aufnahme an ihrer den zweiten Träger führenden Mantel-/Oberfläche Auslässe aufweist, die dazu eingerichtet sind, den zweiten Träger mittels Unterdruck an der zweiten Aufnahme (schlupffrei und dehnungsfrei) zu halten.

In einer weiteren Variante umfasst die Vorrichtung eine dritte Bilderfassungseinrichtung, die - bezogen auf die Förderrichtung des zweiten Trägers - abstromseitig zur Ablageposition angeordnet und dazu vorgesehen und eingerichtet ist, wenigstens eine der Vielzahl elektronischer Teilbaugruppen auf dem zweiten Träger und das auf sie übertragene Bauteil in ihrer Lage relativ zu einander zu erfassen und eine die erfasste Lage repräsentierende Information an die Steuerung zu signalisieren.

In einer weiteren Variante umfasst die Vorrichtung eine achte Fördereinrichtung, die dazu vorgesehen und eingerichtet ist, die zweite Bilderfassungseinrichtung relativ zu der zweiten Aufnahme und der Ablageposition zu fördern, um wenigstens eine Bauteil-Ablagestelle auf dem zweiten Träger durch die zweite Bilderfassungseinrichtung zu erfassen und/oder, um wenigstens eine der Vielzahl elektronischer Teilbaugruppen auf dem zweiten Träger in ihrer Lage zu erfassen und eine die erfasste Lage repräsentierende Information an die Steuerung zu signalisieren; und /oder eine neunte Fördereinrichtung, die dazu vorgesehen und eingerichtet ist, die dritte Bilderfassungseinrichtung relativ zu der zweiten Aufnahme und der Ablageposition zu fördern, um wenigstens eine der Vielzahl elektronischer Teilbaugruppen auf dem zweiten Träger und das auf sie übertragene Bauteil in ihrer Lage relativ zu einander zu erfassen und eine die erfasste Lage repräsentierende Information an die Steuerung zu signalisieren.

Alternativ sind die zweite und/oder die dritte Bilderfassungseinrichtung schwenkbar an der zweiten Aufnahme gelagert und in ihrer Ausrichtung auf die Bauteil-Ablagestelle bzw. die elektronischen Teilbaugruppen auf dem zweiten Träger und das auf sie übertragene Bauteil elektronisch gesteuert oder manuell verstellbar.

Zur Lösung dieser Aufgabe wird außerdem eine weitere Vorrichtung zum Auftragen von Klebstoff aus einem Vorrat auf einen zweiten Träger vorgeschlagen, wobei der zweite Träger quasi-endlos ausgestaltet ist und in seiner Längs- und Quererstreckung eine Vielzahl elektronischer Teilbaugruppen trägt, zu denen der Klebstoff aufzutragen ist um danach ein Bauteil zu einer der Teilbaugruppen zu übertragen, und wobei die weitere Vorrichtung umfasst: eine dritte Aufnahme, die dazu eingerichtet ist, dass über sie der zweite Träger entlang seiner Längserstreckung in einer Förderrichtung des zweiten Trägers zu führen ist; eine Spendeeinrichtung für Klebstoff, die dazu eingerichtet ist, gesteuert und dosiert Klebstoff zu der dritten Aufnahme hin auf eine Klebe-Stelle am zweiten Träger an einer Klebstoff-Ausbring-position auszubringen, an der sich eine der Vielzahl elektronischer Teilbaugruppen befindet; eine elfte Fördereinrichtung, die dazu vorgesehen und eingerichtet ist, die Spendeeinrichtung für Klebstoff quer zur Förderrichtung des zweiten Trägers relativ zu der dritten Aufnahme zu bewegen; eine vierte Bilderfassungseinrichtung, die aufstromseitig zur Klebstoff-Ausbringposition angeordnet und dazu vorgesehen und eingerichtet ist, wenigstens eine der Vielzahl elektronischer Teilbaugruppen auf dem zweiten Träger in ihrer Lage relativ zu der dritten Aufnahme zu erfassen und eine die erfasste Lage repräsentierende Information an die Steuerung zu signalisieren; eine zwölfte Fördereinrichtung, die dazu vorgesehen und eingerichtet ist, in Ansprache auf von der Steuerung signalisierte Information, den zweiten Träger in seiner Lage relativ zur Klebstoff-Ausbringposition so zu fördern, dass die wenigstens eine der Vielzahl elektronischer Teilbaugruppen mit der Klebe-Stelle auf dem zweiten Träger zu der Klebstoff-Ausbringposition auf der den zweiten Träger führenden dritten Aufnahme gelangt.

Die Vorrichtung zum Klebstoff-Ausbringen ist vorteilhaft im Zusammenwirken mit und aufstromseitig zu der Vorrichtung zum Übertragen elektronischer Bauteile von einem ersten Träger zu einem zweiten Träger, aber auch unabhängig davon einzusetzen.

Auch bei der Vorrichtung zum Klebstoff-Ausbringen gilt, dass sie erlaubt, mehrreihiges Bandmaterial als zweiten Träger zu verwenden, wobei die verringerte Komplexität und der höhere Durchsatz beim Klebstoff-Ausbringen auf den Bereich von Anlagen übertragen, die in der Lage sind, mehrreihiges Bahnmaterial verarbeiten. Die hier vorgeschlagene Lösung zum Klebstoff-Ausbringen erlaubt auch, die bisherige Inspektion des zweiten Trägers an der Klebstoff-Ausbring-Position zu ersetzen. Somit können auch wenig bis gar nicht transparente zweite Träger ohne Genauigkeitseinbußen beim Klebstoff-Ausbringen vor der Bauteil-Ablage verwendet werden.

Herkömmliche DDA Anlagen für einreihiges Bahnmaterial nutzen zur Erkennung der Klebstoff-Ausbring-Position auf dem Bahnmaterial vor dem Klebstoff-Ausbringen eine Kamera, die direkt im Ablagebereich auf der Rück-/)Unterseite des Bahnmaterials des zweiten Trägers angebracht ist. Durch diese Anordnung können herkömmliche DDA Anlagen nur volltransparente Materialien, z. B. PET, ohne Einschränkung der Ablage-Genauigkeit verarbeiten, intransparente Materialien als zweiter Träger sind generell nicht möglich.

Die vorgeschlagene Lösung erfasst die Klebe-Stelle auf dem Bahnmaterial (räumlich / zeitlich) vor dem eigentlichen Klebstoff-Ausbringen, wobei die vierte Bilderfassungseinrichtung direkt, also nicht durch den zweiten Träger hindurch, sondern die jeweilige Klebe-Stelle - im Zusammenhang mit der jeweiligen elektronischen Teilbaugruppe - auf dem zweiten Träger selbst erfasst. Dann wird der zweite Träger so kontrolliert zu der Klebstoff-Ausbring-Position gefördert, dass die Klebe-Stelle möglichst präzise mit der Position des Auslasses der Spendeeinrichtung für Klebstoff fluchtet, wenn die Spendeeinrichtung (dosiert eine Portion) Klebstoff auf die Klebe-Stelle ausbringt.

In einer Variante ist die vierte Bilderfassungseinrichtung, die - bezogen auf die Förderrichtung des zweiten Trägers - aufstromseitig zur Klebstoff-Ausbring-Position bei dem zweiten Träger angeordnet und dazu vorgesehen und eingerichtet, quer zur Förderrichtung des zweiten Trägers jeweils ein oder mehrere der Vielzahl elektronischer Teilbaugruppen auf dem zweiten Träger in ihrer Lage relativ zu der dritten Aufnahme zu erfassen und eine die erfasste Lage repräsentierende Information an die Steuerung zu signalisieren.

In einer Variante ist der zwölften Fördereinrichtung eine zweite Sensoreinrichtung zugeordnet, die dazu vorgesehen und eingerichtet ist, der Steuerung Information zu Förderrichtung und Förderweg des zweiten Trägers relativ zur Klebstoff-Ausbring-Position zu signalisieren.

In einer Variante ist die Steuerung dazu vorgesehen und eingerichtet, basierend auf der Information der vierten Bilderfassungseinrichtung zur Lage der wenigstens einen elektronische Teilbaugruppe und der Information zu Förderrichtung und Förderweg des zweiten Trägers sowie basierend auf der Information der vierten Bilderfassungseinrichtung zur Lage wenigstens eines der Bauteile relativ zur Klebstoff-Ausbring-Position die elfte Fördereinrichtung anzusteuern, um die Spendeeinrichtung quer zur Förderrichtung des zweiten Trägers zu der Ablageposition zu bewegen, und die Spendeeinrichtung im Sinne eines Trennens des Bauteils von dem ersten Träger zu aktivieren.

In einer Variante umfasst die Vorrichtung eine dreizehnte Fördereinrichtung, die dazu vorgesehen und eingerichtet ist, in Ansprache auf von der Steuerung signalisierte Information, den zweiten Träger so (schlupffrei und so dehnungsfrei) entlang der Förderrichtung über die zweite Aufnahme zu fördern, dass die wenigstens eine der Vielzahl elektronischer Teilbaugruppen auf dem zweiten Träger zu der Klebstoff-Ausbring-Position auf der den zweiten Träger führenden zweiten Aufnahme gelangt.

In einer weiteren Variante der Vorrichtung umfasst die dritte Aufnahme eine (kreis-)zylindrische Trommel oder eine konvex gekrümmte Fläche, über die der zweite Träger zu der Ablageposition auf der dritten Aufnahme gelangt, wobei in einer Variante die zweite Aufnahme an ihrer den zweiten Träger führenden Mantel-/Oberfläche Auslässe aufweist, die dazu eingerichtet sind, den zweiten Träger mittels Unterdruck an der dritten Aufnahme (schlupffrei und dehnungsfrei) zu halten.

In einer weiteren Variante umfasst die Vorrichtung eine fünfte Bilderfassungseinrichtung, die - bezogen auf die Förderrichtung des zweiten Trägers - abstromseitig zur Klebstoff-Ausbring-Position angeordnet und dazu vorgesehen und eingerichtet ist, wenigstens eine der Vielzahl elektronischer Teilbaugruppen auf dem zweiten Träger und den auf sie ausgebrachten Klebstoff in ihrer Lage relativ zu einander zu erfassen und eine die erfasste Lage repräsentierende Information an die Steuerung zu signalisieren.

In einer weiteren Variante umfasst die Vorrichtung eine vierzehnte Fördereinrichtung, die dazu vorgesehen und eingerichtet ist, die vierte Bilderfassungseinrichtung relativ zu der dritten Aufqnahme und der Klebstoff-Ausbring-Position zu fördern, um wenigstens eine Klebestelle auf dem zweiten Träger durch die die fünfte Bilderfassungseinrichtung zu erfassen, um wenigstens eine der Vielzahl elektronischer Teilbaugruppen auf dem zweiten Träger in ihrer Lage zu erfassen und eine die erfasste Lage repräsentierende Information an die Steuerung zu signalisieren; und /oder eine fünfzehnte Fördereinrichtung, die dazu vorgesehen und eingerichtet ist, die fünfte Bilderfassungseinrichtung relativ zu der dritten Aufnahme und der Klebstoff-Ausbring-Position zu fördern, um wenigstens eine der Vielzahl elektronischer Teilbaugruppen auf dem zweiten Träger und den auf sie ausgebrachten Klebstoff in ihrer Lage relativ zu einander zu erfassen und eine die erfasste Lage repräsentierende Information an die Steuerung zu signalisieren.

Alternativ sind die vierte und/oder die fünfte Bilderfassungseinrichtung schwenkbar gelagert und in ihrer Ausrichtung elektronisch gesteuert oder manuell verstellbar.

In den vorstehend beschriebenen Vorrichtungen zum Übertragen elektronischer Bauteile von einem ersten Träger zu einem zweiten Träger und/oder zum Auftragen von Klebstoff aus einem Vorrat auf einen zweiten Träger können die zweiten bis fünften Bilderfassungseinrichtungen wie folgt ausgestaltet sein. Einer Bilderfassungseinrichtung ist eine Beleuchtungseinrichtung zugeordnet, wobei die Beleuchtungseinrichtung dazu eingerichtet ist, Licht unterschiedlicher Wellenlänge auf eine zweite Aufnahme zu richten, die dazu eingerichtet ist, ein auf dem zweiten Träger befindliches Objekt zu tragen, das von der Bilderfassungseinrichtung aufzunehmen ist, eine sechzehnte, siebzehnte, achtzehnte und/oder neunzehnte Fördereinrichtung ist dazu eingerichtet, die jeweilige Bilderfassungseinrichtung mit der ihr zugeordneten Beleuchtungseinrichtung entlang der zweiten Aufnahme zu fördern, und eine achte, neunte, vierzehnte, und/oder fünfzehnte Fördereinrichtung, die dazu vorgesehen und eingerichtet ist, die jeweilige zweite, dritte, vierte und/oder fünfte Bilderfassungseinrichtung relativ zu der jeweilige zweiten und/oder dritten Aufnahme und der Bauteil-Ablageposition oder der Klebstoff-Ausbring-Position entlang der Förderrichtung des zweiten Träger zu fördern.

In einer Variante der Bilderfassungseinrichtung umfasst die Beleuchtungseinrichtung eine Weiß-Licht-, eine Rot-Licht-, und/oder eine (Ultra-)Blau-Licht-Quelle.

In einer Variante der Beleuchtungseinrichtung sind die Rot-Licht-, und/oder die (Ultra-)Blau-Licht-Quelle als Ringlichtquelle ausgestaltet, die einen Erfassungsbereich der Bilderfassungseinrichtung zumindest teilweise umgibt.

In einer Variante der Bilderfassungseinrichtung ist die Weiß-Licht-Quelle auf einer von dem Erfassungsbereich der Bilderfassungseinrichtung abliegenden Seite einer zumindest teilweise licht-durchlässigen Strahlumlenkung angeordnet.

In einer Variante der Bilderfassungseinrichtung umfasst die Bilderfassungseinrichtung eine Fokussieroptik, die einen fest einstellbaren Abstand zur ihr zugewandten Seite einer zumindest teilweise Licht-durchlässigen Strahlumlenkung angeordnet ist.

Auch wenn einige der voranstehend beschriebenen Aspekte in Bezug auf die Betriebsweise der Vorrichtung beschrieben wurden, so können diese Aspekte auch die Struktur der Vorrichtung betreffen. Genauso können die voranstehend in Bezug auf die Vorrichtung beschriebenen Aspekte in entsprechender Weise auf die Betriebsweise zutreffen. Die einzelnen Aspekte der Vorrichtung und der Betriebsweise sind zwar im Zusammenhang beschrieben um ihre Interaktion zu erläutern; sie sind jedoch auch unabhängig voneinander, den anderen Vorrichtungen und anderen Betriebsweisen offenbart.

### Kurzbeschreibung der Zeichnungen

Weitere Ziele, Merkmale, Vorteile und Anwendungsmöglichkeiten ergeben sich aus der nachfolgenden Beschreibung von Ausführungsbeispielen mit Bezug auf die zugehörigen Zeichnungen. Die Abmessungen und Proportionen der in den Figuren gezeigten Komponenten sind hierbei nicht unbedingt maßstäblich; sie können bei zu implementierenden Ausführungsformen vom hier Veranschaulichten abweichen.
- Figur 1: zeigt eine schematische seitliche Draufsicht der Vorrichtung zum Übertragen elektronischer Bauteile von einem ersten Träger zu einem zweiten Träger und einer Vorrichtung zum Aufbringen von Klebstoff auf den zweiten Träger.
- Fig. 1a: zeigt eine schematische perspektivische Ansicht einer zweiten Aufnahme mit einem teilweise gezeigten zweiten Träger, auf dem ein Bauteil abzulegen ist.
- Fig. 2: zeigt eine schematische Draufsicht auf einen in X-/Y-/Theta-Koordinaten verstellbaren Tisch.
- Fig. 3: zeigt eine schematische Draufsicht auf die zweite bis fünfte Bilderfassungseinrichtung.

Die hier beschriebenen Verfahrens- und Vorrichtungsvarianten sowie deren Funktions- und Betriebsaspekte dienen lediglich dem besseren Verständnis ihrer Struktur, Funktionsweise und Eigenschaften. Die Figuren sind teilweise schematisch, wobei wesentliche Eigenschaften und Effekte zum Teil deutlich vergrößert dargestellt sind, um die Funktionen, Wirkprinzipien, technischen Ausgestaltungen und Merkmale zu verdeutlichen.

### Detaillierte Beschreibung

In den Figuren sind einander entsprechende oder funktionsähnliche Bauteile mit übereinstimmenden Bezugszeichen versehen. Das Verfahren und die Vorrichtung werden nun anhand von Ausführungsbeispielen beschrieben.

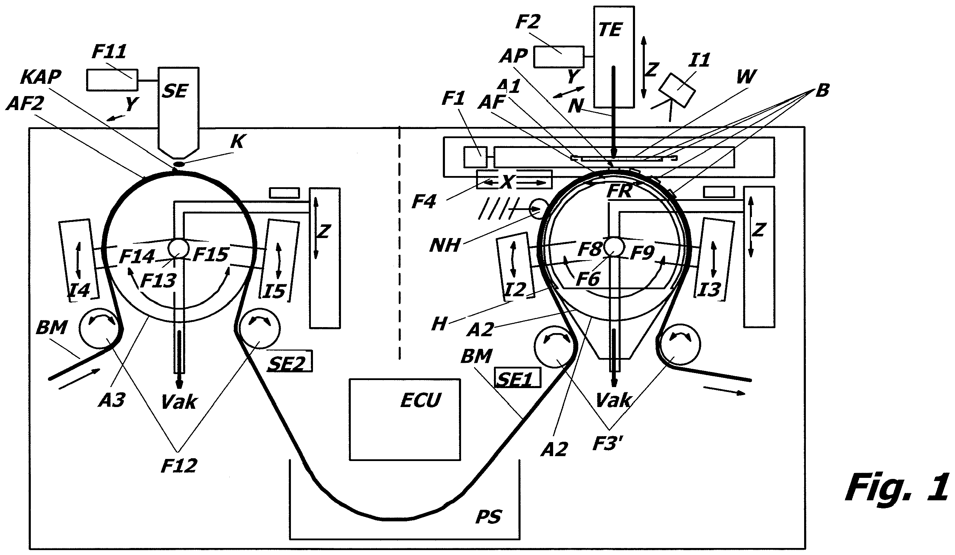

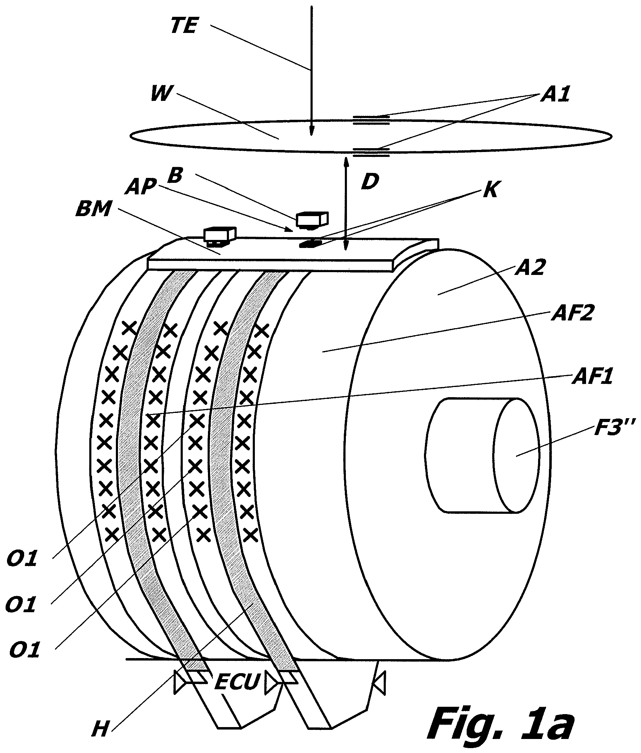

Die Fig. 1 zeigt (auf der rechten Seite) eine Vorrichtung 100 zum Übertragen elektronischer Bauteile B von einem ersten Träger W zu einem zweiten Träger BM. Der erste Träger W hat in dieser Variante die Gestalt eines hier etwa kreisrunden Halbleiter-Bauteil-Wafers und trägt eine Vielzahl vereinzelter Bauteile B, die von ihm in weiter unten beschriebener Weise lösbar sind. Der zweite Träger BM ist als quasi-endloses Bandmaterial ausgestaltet und trägt in seiner Längs- und/oder Quererstreckung eine Vielzahl elektronischer Teilbaugruppen ANT. In der hier gezeigten Variante sind die Teilbaugruppen ANT gedruckte oder als Draht verlegte Antennenabschnitte eines RFID-Moduls. Auf jede der Vielzahl elektronischer Teilbaugruppen ANT ist jeweils eines der Bauteile B von dem ersten Träger W zu übertragen. Die Vorrichtung hat eine erste Aufnahme A1, die dazu eingerichtet ist, den ersten Träger W aufzunehmen. Die erste Aufnahme A1 ist in ihrer Gestalt an den ersten Träger W angepasst.

Eine zweite Aufnahme A2 hat in der gezeigten Variante die Gestalt einer kreiszylindrischen Trommel. Über die zylindermantel-förmige Außenwand wird der zweite Träger BM entlang seiner Längserstreckung in einer Förderrichtung FR geführt. Details hierzu sind weiter unten erläutert. Die erste Aufnahme A1 nimmt den ersten Träger W so auf, dass die von ihm getragenen Bauteile B zu der zweiten Aufnahme A2 hin orientiert sind. Auf der von der zweiten Aufnahme A2 abliegenden Seite der ersten Aufnahme A1 ist eine Trenneinrichtung TE vorgesehen. Der erste Träger W hat eine der Trenneinrichtung TE zugewandte erste Seite und eine von der Trenneinrichtung TE abgewandte zweite Seite, die dem zweiten Träger BM auf/ an der zweiten Aufnahme A2 zugewandt ist. Auf der zweiten Seite des ersten Trägers W ist die Vielzahl der Bauteile B lösbar aufgebracht. Die Trenneinrichtung TE dient dazu, die Bauteile B von dem ersten Träger W berührend oder berührungslos abzutrennen, um sie an einer Ablageposition AP auf den zweiten Träger BM zu übertragen.

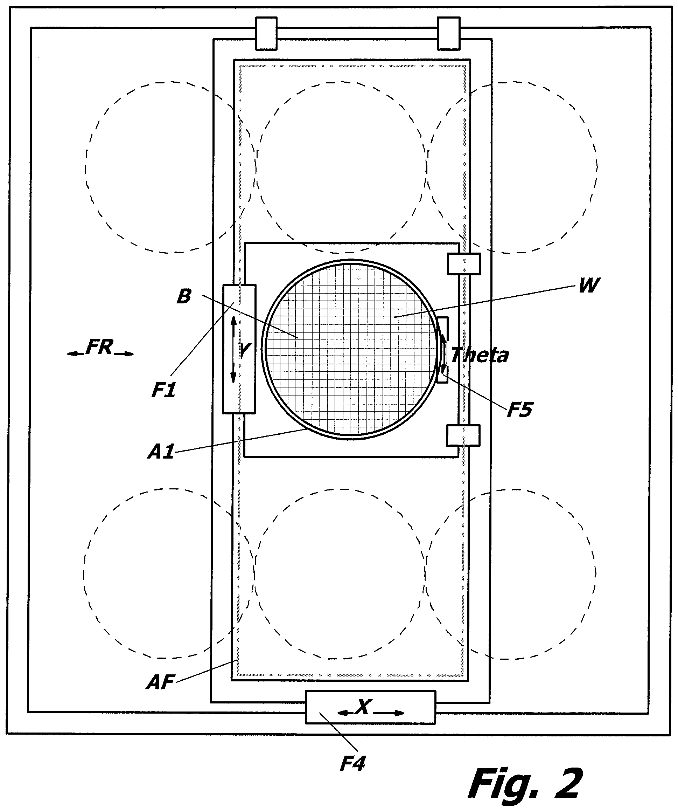

Die erste Aufnahme A1 ist Teil eines in X-/Y-/Theta-Koordinaten verstellbaren Tisches, dessen einzelne X-/Y-Achsen und Drehstellung Theta jeweils mit einer von einer elektronischen Steuerung ECU angesteuerten Fördereinrichtung zu verstellen sind. Insbesondere ist eine erste Fördereinrichtung F1 in Gestalt eines Linear-Servoantriebs dazu vorgesehen und eingerichtet, die erste Aufnahme A1 quer zur Förderrichtung FR des zweiten Trägers BM relativ zu der zweiten Aufnahme A2 zu bewegen. (Siehe auch Fig. 2).

Eine zweite Fördereinrichtung F2 in Gestalt eines Linear-Servoantriebs ist in einer Ausführungsform dazu vorgesehen und eingerichtet, die Trenneinrichtung TE quer zur Förderrichtung FR des zweiten Trägers BM relativ zu der zweiten Aufnahme A2 zu bewegen.

Eine erste Bilderfassungseinrichtung I1 in Gestalt einer Kamera ist der Trenneinrichtung TE zugeordnet und dient dazu, in der Draufsicht wenigstens eines der Bauteile B in seiner Lage relativ zu einer Ablageposition AP auf der den zweiten Träger BM führenden zweiten Aufnahme A2 zu erfassen.

Eine zweite Bilderfassungseinrichtung I2 ist aufstromseitig zur Ablageposition AP angeordnet und der zweiten Aufnahme A2 zugeordnet. Diese zweite Bilderfassungseinrichtung I2 ist in Varianten mit mehreren nebeneinander angeordneten Heizungen (siehe Fig. 1a) an der zweiten Aufnahme A2 (für zweite Träger BM mit in Querrichtung mehreren Teilbaugruppen ANT) in Längserstreckung der trommelförmigen zweiten Aufnahme A2, also quer zur Förderrichtung FR des zweiten Trägers BM gesteuert verfahrbar, und/oder um einen vorgestimmten Winkelbetrag entlang des Umfangs an der Mantelfläche der trommelförmigen zweiten Aufnahme A2 manuell oder motorisch verstellbar. Beispielsweise kann die Bilderfassungseinrichtung I2 über einen Schwenkarm mit der zweiten Aufnahme A2 verbunden sein. Bei Varianten für zweite Träger BM mit einreihigen Teilbaugruppen ANT ist die zweite Bilderfassungseinrichtung I2 starr zu montieren und ihr Blickfeld wird einmalig justiert.

Die zweite Bilderfassungseinrichtung I2 dient dazu, wenigstens eine der Vielzahl elektronischer Teilbaugruppen ANT auf dem zweiten Träger BM in ihrer Lage relativ zu der zweiten Aufnahme A2 zu erfassen und eine die erfasste Lage repräsentierende Information an eine Steuerung ECU zu signalisieren.

Eine dritte Fördereinrichtung F3' für den zweiten Träger BM ist in dieser Ausgestaltung durch zwei gesteuert anzutreibende Transportwalzen gebildet, die auf- und abstromseitig zu der trommelförmigen zweiten Aufnahme A2 angeordnet sind, und um die der zweite Träger BM geführt ist. In Ansprache auf von der Steuerung ECU signalisierte Information, wird der zweite Träger BM durch die zwei gesteuert anzutreibenden Transportwalzen in seiner Lage relativ zu der Ablageposition AP so gefördert, dass die wenigstens eine der Vielzahl elektronischer Teilbaugruppen ANT auf dem zweiten Träger BM zu der Ablageposition AP auf der den zweiten Träger BM führenden zweiten Aufnahme A2 gelangt.

Alternativ oder kumulativ ist eine weitere dritte Fördereinrichtung F3" für den zweiten Träger BM dazu vorgesehen und eingerichtet, in Ansprache von auf einer Steuerung signalisierte Information, den zweiten Träger BM in seiner Lage relativ zu der Ablageposition AP so zu fördern, dass eine elektronische Teilbaugruppe ANT auf dem zweiten Träger BM zu der Ablageposition AP auf der den zweiten Träger BM führenden zweiten Aufnahme A2 gelangt.

Diese alternative / kumulative Ausgestaltung der weiteren Fördereinrichtung F3" für den zweiten Träger BM ist, wenn die zweite Aufnahme A2 als kreiszylindrische Trommel ausgestaltet ist, ein motorischer Dreh-Antrieb der Trommel (siehe Fig. 1a).

Diese alternative / kumulative Ausgestaltung der weiteren Fördereinrichtung F3" ist, wenn die zweite Aufnahme A2 als zur ersten Aufnahme A1 hin konvex gebogene oder gekrümmte, ortsfeste Fläche gestaltet ist, ein zu beiden Seiten einer jeweiligen Heizung H angeordnete Antrieb für den zweiten Träger BM.

Dabei sei verstanden, dass sich die Ablageposition AP in Längsrichtung des zweiten Trägers BM als auch in dessen Quererstreckung verändern kann, um ein Bauteil B präzise an der vorgesehenen Stelle der Teilbaugruppe ANT abzulegen, während sich ein entsprechender Bereich des zweiten Trägers BM auf der zweiten Aufnahme A2 befindet und mit dem Bauteil B am ersten Träger W zur Deckung zu bringen ist. Dementsprechend ist auch der erste Träger W durch die Steuerung ECU gesteuert, sowohl in Längsrichtung des zweiten Trägers BM als auch in dessen Quererstreckung, zu verlagern.

Ersichtlich ist ein mehrreihiges Bandmaterial als zweiter Träger BM verwendet. Hierunter sei Bandmaterial verstanden, das in seiner Quererstreckung Reihen mit zum Beispiel zwei, drei oder mehr Teilbaugruppen ANT trägt, die sich in Längsrichtung (Förderrichtung) des Bandmaterials quasi-endlos wiederholen. Als zweiter Träger BM kann wenig bis gar nicht transparentes Trägermaterial ohne Genauigkeitseinbußen bei der Bauteil-Ablage verwendet werden.

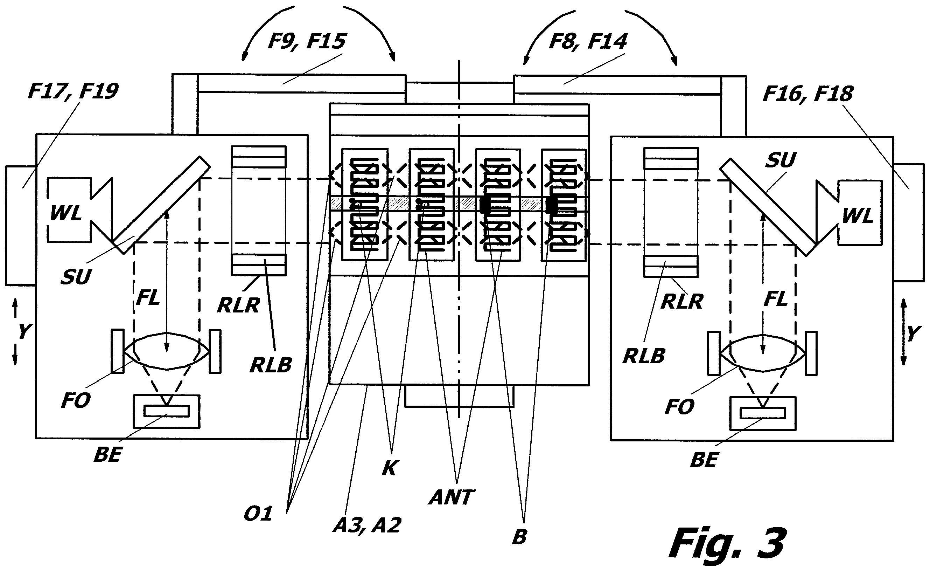

Die zweite Aufnahme A2 ist in der in Fig. 1a gezeigten Ausgestaltung eine längs der Zylinderachse (siehe auch Fig. 3) mehrteilige, formstarre, etwa kreiszylindrische Trommel, deren einzelne Abschnitte AF1, AF2 ortsfest oder durch einen Antrieb oder durch entsprechende Antriebe/Fördereinrichtungen zu rotieren sind. Hierbei ist in einer Variante der eine der beiden Abschnitte AF1, AF2 der etwa kreiszylindrischen Trommel feststehend, und der andere Teil rotierend. Zwischen zwei Abschnitten AF1, AF2 der etwa kreiszylindrischen Trommel der zweiten Aufnahme A2 ist eine gegenüber diesen zwei Abschnitten AF1, AF2 ortsfeste Heizung H in Gestalt einer in etwa ringförmigen Trägerscheibe angeordnet, an deren Umfang die Heizung H angeordnet ist. Der Außenumfang der ringförmigen Trägerscheibe entspricht in etwa dem Durchmesser der kreiszylindrischen Trommel der zweiten Aufnahme A2 oder ist geringfügig größer. Die Heizung H ist dazu vorgesehen und eingerichtet, den zweiten Träger BM und insbesondere die darauf befindlichen Teilbaugruppen ANT vor, an, und/oder nach der Ablageposition AP von der von der ersten Aufnahme A1 abliegenden Seite der zweiten Aufnahme A2 her zu temperieren.

Alternativ können beidseitig zu der ortsfesten Heizung H die beiden Abschnitte AF1, AF2 drehbar sein. In einer weiteren Variante ist ein- oder beidseitig zwischen der ortsfesten Heizung H und den beiden ebenfalls ortsfesten Abschnitten AF1, AF2 jeweils ein rotierender Teil mit den unter Unterdruck stehenden Öffnungen O1 vorgesehen. Der rotierende Teil kann ein ringförmiger Antrieb sein. Ein oder mehrere der zweiten Aufnahme A2 zugeordnete rotierende, motorisch angetriebene Teile bilden die weitere Fördereinrichtung F3.

Insbesondere ist im Bereich aufstrom- und/oder abstromseitig und/oder entlang der Quererstreckung der gekrümmten Anlagefläche AF oder zumindest der Ablageposition AP wenigstens eine Heizung H angeordnet, die in Ansprache auf von der Steuerung signalisierte Information Wärme abzugeben eingerichtet ist. In einer nicht weiter veranschaulichten Variante mit mehreren Heizzonen sind diese dazu vorgesehen und eingerichtet, in Ansprache auf von der Steuerung ECU signalisierte Information unabhängig voneinander Wärme abzugeben.

Die kreiszylindrische Trommel der zweiten Aufnahme A2 hat eine gekrümmte Anlagefläche AF, die mit einer Unterdruckquelle Vak zu verbindende Öffnungen O1 aufweist. Sofern der zweite Träger BM um die gekrümmte Anlagefläche AF geführt und die Unterdruckquelle Vak mit den Öffnungen O1 verbunden sind, wird durch den Unterdruck der zweite Träger BM in enge Anlage an die gekrümmte Anlagefläche AF gebracht. In einer Variante der Vorrichtung umfasst die weitere Fördereinrichtung F3 zwei Antriebe, die die einzelnen Abschnitte AF1, AF2 synchron in Drehung versetzen um den zweiten Träger BM, gesteuert durch die Signalisierung aus der ECU, an der Ablageposition AP entlang zu fördern.

In Fig. 1a ist der besseren Übersicht wegen nur ein Abschnitt des zweiten Trägers BM gezeigt, der sich unmittelbar in der Ablageposition AP befindet, und auf den ein Bauteil B von dem ersten Träger W mittels der Trenneinrichtung TE bereits übertragen ist, und ein Bauteil B von dem ersten Träger W mittels der Trenneinrichtung TE übertragen wird.

In einer nicht weiter bildlich veranschaulichten Variante übergreift ein feststehender Steg die Heizung H parallel zur Mittellängsachse der kreiszylindrischen Trommel. Damit wird der zweite Träger BM von der Heizung kontrolliert abgehoben, während er über die gekrümmte Anlagefläche AF geführt wird.

Die Heizung dient dazu, auf dem zweiten Träger BM befindliche elektronische Teilbaugruppen ANT vor der Ablageposition AP und/oder im Bereich vor der Ablageposition AP und/oder nach der Ablageposition ANT zu beheizen. Dazu ist die Heizung H in einer hier gezeigten Variante als den Umfang der zweiten Aufnahme A2 zumindest teilweise nachfolgenden Widerstands-Heizstreifen ausgestaltet, der in separat bestrombare Heizzonen unterteilt ist. So kann die Temperatur der Teilbaugruppen ANT auf dem zweiten Träger BM in kontrollierter Weise so angehoben und wieder abgesenkt werden, dass die Lotverbindung (und ggf. auch die Klebevebindung) zwischen dem jeweiligen Bauteil B, das auf die entsprechende Teilbaugruppe ANT abgelegt wird, sowohl elektrisch als auch mechanisch stabil und zuverlässig ist.

In einer weiteren, nicht weiter veranschaulichten Variante der Vorrichtung ist eine Wärme-Abschirmung in Förderrichtung des zweiten Trägers BM gesehen vor und/oder nach der Ablageposition angeordnet. Alternativ oder kumulativ dazu ist zwischen der gekrümmten Anlage A2 und der Wärme-Abschirmung ein Spalt für den zweiten Träger BM angeordnet. Auf diese Weise wird erreicht, dass die Heizung H den ersten Träger und eine zwischen den Bauteilen B und dem ersten Träger W befindliche Haftschicht nicht oder nur wenig aufheizt.

In der Fig. 1 ist veranschaulicht, wie aufstromseitig der Ablageposition AP / der gekrümmten Anlagefläche AF ein Pufferspeicher PS angeordnet ist, der dazu vorgesehen und eingerichtet ist, einen Vorrat des zweiten Trägers BM aufzunehmen. Dazu ist der zweite Träger BM durch den Pufferspeicher PS in Gestalt eines rechteckigen, nach oben offenen Kastens geführt, der das zweite Träger BM in einer nicht veranschaulichten Variante mit Unterdruck hält oder verzögert.

Eine erste Bilderfassungseinrichtung I1 ist dazu vorgesehen und eingerichtet, im Bereich der Ablageposition AP in einer senkrechten (plus-minus 50°) Draufsicht einen Bildeinzug zumindest eines an dem ersten Träger W befindlichen Bauteils B vorzunehmen und der Steuerung ECU die Lage wenigstens eines Bauteils B zu signalisieren. Zusätzlich ist eine zweite und eine dritte Bilderfassungseinrichtung I2, I3 angeordnet und dazu vorgesehen und eingerichtet, im Bereich aufstrom- bzw. abstromseitig der Ablageposition AP in einer jeweiligen senkrechten (plus-minus 50°) Draufsicht Bildeinzüge von dem zweiten Träger BM ohne / mit dem auf die Teilbaugruppe ANT übertragenen Bauteil B vorzunehmen und der Steuerung ECU zu signalisieren.

Außerdem ist durch eine erste Verstelleinrichtung V1 ein Abstand D zwischen der gekrümmten Anlagefläche AF und der ersten Aufnahme A1 einstellbar.

Entlang dem zweiten Träger BM ist im Bereich aufstrom- und/oder abstromseitig der Ablageposition AP jeweils wenigstens ein Niederhalter NH vorgesehen und dazu eingerichtet, den zweiten Träger BM im Bereich der gekrümmten Anlagefläche AF mit kontrollierter Anpressdruck kontrolliert dem Unterdruck Vak aus den Öffnungen in der Anlagefläche AF auszusetzen.

Der Niederhalter NH ist eine drehbar gelagerte Walze ohne Antrieb, die abschnittweise, nämlich im Bereich der Teilbaugruppen ANT, und längs ihrer Drehachse einen größeren Umfang / eine oder mehrere Verdickungen aufweist. Diese Verdickung orientiert den zweiten Träger BM möglichst früh zur zweiten Aufnahme A2 hin.

Wie in Fig. 1 in der linken Hälfte veranschaulicht, sind im Bereich aufstromseitig der Ablageposition AP eine dritte Aufnahme A3 und eine Spendeeinrichtung SE für Klebstoff K angeordnet. Zwischen der weiteren gekrümmten Anlagefläche AF2 und dem Klebstoff-Spender KS1 wird der zweite Träger (BM) hindurchgeführt. In Ansprache auf von der Steuerung ECU signalisierte Information gibt Spendeeinrichtung SE Klebstoff K auf den zweiten Träger BM portioniert ab.

Im Betrieb der Vorrichtung wird ein elektronisches Bauteil B von dem ersten Träger W zu dem zweiten Träger BM übertragen. Dabei trägt der erste Träger W eine Vielzahl vereinzelter Bauteile von ihm lösbar. Der zweite Träger BM ist quasi-endlos ausgestaltet und trägt in seiner Längserstreckung die Vielzahl elektronischer Teilbaugruppen ANT in einer Spur. Zu jeweils einer elektronischen Teilbaugruppe ANT ist jeweils eines der Bauteile B von dem ersten Träger W zu übertragen. Die Vorgehensweise ist dabei wie folgt:
Der erste Träger W mit den Bauteilen B wird in der ersten Aufnahme A1 aufgenommen. Dabei wird mit der ersten Aufnahme A1 der erste Träger W so aufgenommen, dass die von ihm getragenen Bauteile B zu der zweiten Aufnahme A2, und damit zu den elektronischen Teilbaugruppen ANT hin orientiert sind.

Der zweite Träger BM wird entlang seiner Längserstreckung in einer Förderrichtung des zweiten Trägers BM durch die zweite Aufnahme A2 zu der Ablageposition AP geführt, so dass nacheinander die einzelnen Teilbaugruppen ANT des zweiten Trägers BM die Ablageposition AP passieren.

Der zweite Träger BM wird in Ansprache auf von einer Steuerung signalisierte Information in seiner Lage relativ zu der Ablageposition AP mit einer zweiten Fördereinrichtung F2 so gefördert, dass eine elektronische Teilbaugruppe ANT auf dem zweiten Träger BM zu der Ablageposition AP auf der den zweiten Träger BM führenden zweiten Aufnahme A2 an die Stelle gelangt, an der das jeweilige Bauteil B landen wird.

Die Bauteile B werden von dem ersten Träger W mit einer Trenneinrichtung TE in Gestalt einer durch die elektronische Steuerung kontrollierten Stoßnadel oder eines Laserstrahls berührend oder berührungslos abgetrennt, um sie auf den zweiten Träger BM zu übertragen.

Im Bereich der zweiten Aufnahme A2 wirkt die Heizung H, um den zweiten Träger BM vor, an, und/oder nach der Ablageposition AP von seiner von der ersten Aufnahme A1 abliegenden Seite her zu temperieren.

Die Ablageposition AP auf dem Bahnmaterial des zweiten Träger BM wird räumlich / zeitlich vor der eigentlichen Bauteil-Ablage erfasst. Dabei erfasst die zweite Bilderfassungseinrichtung I2 direkt, also nicht durch den zweiten Träger hindurch, sondern die jeweilige Bauteil-Ablagestelle auf dem zweiten Träger BM selbst. Dann wird der zweite Träger BM so kontrolliert zu der Ablageposition AP gefördert / dort positioniert, dass die Bauteil-Ablagestelle möglichst präzise mit der Position des abzulegenden Bauteils an dem ersten Träger W fluchtet, wenn die Trenneinrichtung TE dieses Bauteil B von dem ersten Träger W trennt und dieses dann in Z-Richtung auf den zweiten Träger BM überträgt.

Durch die Temperierung des zweiten Trägers BM / der elektronischen Teilbaugruppe ANT auf dem zweiten Träger BM durch die Heizung H sind die relevanten Portionen / Bereiche der elektronischen Teilbaugruppe ANT soweit aufgeheizt, dass daran befindliches Lot oder Teile der elektronischen Teilbaugruppe ANT geschmolzen sind, und ein Bauteil mit seinen Kontaktstellen von dem ersten Träger präzise in der Ablageposition AP auf die elektronische Teilbaugruppe ANT übertragen und mit dieser solide und sicher elektrisch und mechanisch verbunden wird. Durch die Streckenführung des zweiten Trägers BM mit den elektronischen Teilbaugruppen ANT entlang der Heizung (ggf. mit einzeln zu temperierenden stufenweise oder stufenlos entlang der Heizung bis zur Ablageposition AP steigenden und anschließend fallenden vorzugebenden Temperatur), welche ein auf das zu temperierende und zu schmelzende Material der elektronischen Teilbaugruppen ANT abzustimmen ist, kann die elektrische und/ oder mechanische Kontaktgabe sehr genau erfolgen.

Die erste Aufnahme A1 mit dem ersten Träger W befindet sich unmittelbar über dem zweiten Träger BM an der zweiten Aufnahme A2. Dabei haben die erste Aufnahme A1 und die Trenneinrichtung TE einen der Breite des zweiten Trägers BM zumindest annähernd entsprechenden Bewegungsraum quer zur Förderrichtung FR des zweiten Trägers BM. (Siehe Fig. 2) Dadurch erstreckt sich der Arbeits- /Bauteil-Ablagebereich in etwa über die Breite des zweiten Trägers BM. Dies gilt insbesondere auch für Varianten, die dazu ausgelegt sind, zweite Träger BM mit in Querrichtung mehreren Teilbaugruppen ANT zu verarbeiten.

Die erste Bilderfassungseinrichtung I1 ist dazu eingerichtet, Bilddaten einer Region zu erfassen, in der die Trenneinrichtung TE zum berührenden oder berührungslosen Interagieren mit wenigstens einem der Bauteile B eingerichtet ist um dieses von dem ersten Träger W zu trennen.

Die Steuerung ECU ist dazu eingerichtet, aus den erfassten Bilddaten Positionsdaten des zu übertragenden Bauteils B zu ermitteln, sowie aufgrund der Positionsdaten Steuerbefehle für die Trenneinrichtung TE und die jeweiligen Fördereinrichtungen F1, ... Fn zu erzeugen.

Die zweite Bilderfassungseinrichtung I2 ist bezogen auf die Förderrichtung X des zweiten Trägers BM aufstromseitig zur Ablageposition AP bei dem zweiten Träger A2 angeordnet und dazu vorgesehen und eingerichtet, quer zur Förderrichtung X des zweiten Trägers BM jeweils ein oder mehrere der Vielzahl elektronischer Teilbaugruppen ANT auf dem zweiten Träger BM in ihrer Lage relativ zu der zweiten Aufnahme zu erfassen und eine die erfasste Lage repräsentierende Information an die Steuerung ECU zu signalisieren.

Der dritten Fördereinrichtung F3 für den zweiten Träger BM, ist eine erste Sensoreinrichtung SE1 zugeordnet, die dazu vorgesehen und eingerichtet ist, der Steuerung ECU Information zu Förderrichtung und Förderweg des zweiten Trägers BM und ggf. der auf dem zweiten Träger BM befindlichen elektronischen Teilbaugruppen relativ zu der Ablageposition AP zu signalisieren.

Die Steuerung ECU dient dazu, basierend auf der Information der zweiten Bilderfassungseinrichtung I2 zur Lage der wenigstens einen elektronische Teilbaugruppe ANT und der Information zu Förderrichtung und Förderweg des zweiten Trägers BM sowie basierend auf der Information der ersten Bilderfassungseinrichtung I1 zur Lage wenigstens eines der Bauteile B relativ zur Ablageposition AP die zweite Fördereinrichtung F2 anzusteuern. So bewirkt die Steuerung ECU, dass bei Varianten, die dazu ausgelegt sind, zweite Träger BM mit in Querrichtung mehreren Teilbaugruppen ANT zu verarbeiten, die Trenneinrichtung TE (in Förderrichtung und) quer zur Förderrichtung X des zweiten Trägers BM zu der Ablageposition AP bewegt wird, und die Trenneinrichtung TE im Sinne eines Trennens des Bauteils B von dem ersten Träger W aktiviert wird. Bei einreihiger Anordnung der elektronischen Teilbaugruppen ANT führt die Trenneinrichtung TE während des Betriebs der Vorrichtung keine Querbewegung sondern lediglich eine Senk-/Hub-Bewegung (in z-Richtung) aus.

Eine vierte Fördereinrichtung F4 dient dazu, in Ansprache auf von der Steuerung ECU signalisierte Information, die erste Aufnahme A1 längs der Förderrichtung FR des zweiten Trägers BM relativ zu der zweiten Aufnahme A2 zu bewegen.

Insgesamt lässt sich so jedes Bauteil B des ersten Trägers W durch entsprechende Ansteuerung der entsprechenden X-/Y-Antriebe der Fördereinrichtungen F1, F4 innerhalb eines strichzweipunktierten Bereiches AF zum Übertragen eines Bauteils B auf den zweiten Träger BM auf der zweiten Aufnahme A2 positionieren. Der strichzweipunktierte Bereich AF kann in einer Variante in Quererstreckung des zweiten Trägers BM größer sein als die Quererstreckung des zweiten Trägers BM.

Eine fünfte Fördereinrichtung F5 dient dazu, in Ansprache auf von der Steuerung ECU signalisierte Information, die erste Aufnahme A1 um einen Winkel Theta relativ zu der zweiten Aufnahme A2 zu drehen.

Die Trenneinrichtung TE ist in einer Variante dazu eingerichtet ist, die Bauteile B von dem ersten Träger W berührend abzutrennen. Dazu hat sie eine Stoßnadel N, die dazu eingerichtet und dimensioniert ist, in Ansprache auf von der Steuerung ECU signalisierte Information den ersten Träger W (in Fig. 1 von oben) zu punktieren, um jeweils eines der Bauteile B von dem ersten Träger W abzulösen und auf den zweiten Träger BM zu übertragen. In einer zweiten Variante ist sie dazu eingerichtet, die Bauteile B von dem ersten Träger W berührungslos abzutrennen. Dazu hat die Trenneinrichtung TE eine steuerbare Energiequelle, die dazu eingerichtet und dimensioniert ist, in Ansprache auf von der Steuerung ECU signalisierte Information den ersten Träger W mit zum Beispiel Laser-Energie zu beschicken, um jeweils eines der Bauteile B von dem ersten Träger W abzulösen und auf den zweiten Träger BM zu übertragen.

Die zweite Aufnahme A2 ist eine kreis-zylindrische Trommel oder eine konvex gekrümmte Fläche, über die der zweite Träger BM zu der Ablageposition AP auf der zweiten Aufnahme A2 gelangt. In einer Variante hat die zweite Aufnahme A2 an ihrer den zweiten Träger BM führenden Mantel-/Oberfläche eine Vielzahl kleiner Auslässe um den zweiten Träger BM mittels Unterdruck Vak an der zweiten Aufnahme A2 schlupffrei und dehnungsfrei zu halten.

In einer Variante kann die Mantel-/Oberfläche der zweiten Aufnahme so eingerichtet sein oder der Unterdruck Vak so steuerbar ist, dass an der Mantel-/Oberfläche unterhalb der Ablageposition kein Unterdruck Vak anliegt, sondern lediglich aufstromseitig und abstromseitig von der Ablageposition AP. Somit wird aufstromseitig und abstromseitig von der Ablageposition AP der zweite Träger BM mit Unterdruck gehalten.

In einer Variante kann die zweite Aufnahme A2 mit einer Verstelleinrichtung in Z-Richtung zur ersten Aufnahme A1 hin und von der ersten Aufnahme A1 weg bewegt werden, um einen Abstand zwischen der ersten und zweiten Aufnahme einzustellen.

In einer weiteren Variante kann in die zweite Aufnahme A2 und/oder die dritte Aufnahme A3 zumindest an einem Teil des jeweiligen Bereichs an dem der zweite Träger BM nicht an der jeweiligen Aufnahme A2 oder A3 anliegt, Druckluft eingebracht werden, welche durch die Öffnungen austritt, um ggf. mit der Zeit in die Vakuumlöcher eingesaugte Verschmutzungen abzublasen.

Eine dritte Bilderfassungseinrichtung I3 ist bezogen auf die Förderrichtung FR des zweiten Trägers BM abstromseitig zur Ablageposition AP bei der zweiten Aufnahme A2 angeordnet. Sie dient dazu, wenigstens eine der Vielzahl elektronischer Teilbaugruppen ANT auf dem zweiten Träger BM und das auf sie übertragene Bauteil B in ihrer Lage relativ zu einander zu erfassen und eine die erfasste Lage repräsentierende Information an die Steuerung ECU zu signalisieren.

Eine achte Fördereinrichtung F8 dient dazu, die zweite Bilderfassungseinrichtung I2 relativ zu der zweiten Aufnahme A2 und der Ablageposition AP zu fördern, um wenigstens eine Bauteil-Ablagestelle auf dem zweiten Träger BM durch die zweite Bilderfassungseinrichtung I2 zu erfassen. Die zweite Bilderfassungseinrichtung I2 ist bei Varianten, die dazu ausgelegt sind, zweite Träger BM mit in Querrichtung mehreren Teilbaugruppen ANT zu verarbeiten, in Längserstreckung der trommelförmigen zweiten Aufnahme A2, also quer zur Förderrichtung FR des zweiten Trägers BM, und/oder um einen vorgestimmten Winkelbetrag entlang des Umfangs an der Mantelfläche der trommelförmigen zweiten Aufnahme A2 gesteuert verfahrbar. Alternativ dazu wird der Winkel vor Betriebsaufnahme manuell eingestellt. Bei Varianten für zweite Träger BM mit einreihigen Teilbaugruppen ANT ist die zweite Bilderfassungseinrichtung I2 starr zu montieren und ihr Blickfeld wird einmalig justiert.

Auf diese Weise kann auch wenigstens eine der Vielzahl elektronischer Teilbaugruppen ANT auf dem zweiten Träger BM in ihrer Lage erfasst werden um eine die erfasste Lage repräsentierende Information an die Steuerung ECU zu signalisieren. Des weiterein ist in dieser Variante eine neunte Fördereinrichtung F9 vorgesehen, um die dritte Bilderfassungseinrichtung I3 relativ zu der zweiten Aufnahme A2 und der Ablageposition AP zu fördern in analoger Weise wie dies die achte Fördereinrichtung F8 für die zweite Bilderfassungseinrichtung I2 ausführt. Damit kann die dritte Bilderfassungseinrichtung I3 wenigstens eine der Vielzahl elektronischer Teilbaugruppen ANT auf dem zweiten Träger BM und das auf sie übertragene Bauteil B in ihrer Lage relativ zu einander zu erfassen und eine die erfasste Lage repräsentierende Information an die Steuerung ECU zu signalisieren.

Eine weitere (Teil-)Vorrichtung, wie sie in Fig. 1 auf der linken Seite veranschaulicht ist, dient zum Auftragen von Klebstoff K aus einem Vorrat auf einen zweiten Träger BM. Wie bereits erwähnt ist der zweite Träger BM quasi-endlos ausgestaltet und trägt in seiner Längs- und/ oder Quererstreckung eine Vielzahl elektronischer Teilbaugruppen ANT, zu denen der Klebstoff K aufzutragen ist um danach ein Bauteil B zu einer der Teilbaugruppen ANT zu übertragen. Die weitere Vorrichtung umfasst eine dritte Aufnahme A3, die dazu dient, dass über sie der zweite Träger BM entlang seiner Längserstreckung in einer Förderrichtung FR des zweiten Trägers BM zu führen ist.

Eine Spendeeinrichtung SE für Klebstoff K ist in Fig. 1 oberhalb der dritten Aufnahme A3 vorgesehen um gesteuert und dosiert Klebstoff K zu der dritten Aufnahme A3 hin auf eine Klebe-Stelle KS am zweiten Träger BM an einer Klebstoff-Ausbringposition KAP auszubringen, an der sich eine der Vielzahl elektronischer Teilbaugruppen ANT befindet.

Eine elfte Fördereinrichtung F11 dient dazu, die Spendeeinrichtung SE für Klebstoff K quer zur Förderrichtung FR des zweiten Trägers BM relativ zu der dritten Aufnahme A3 zu bewegen. Eine vierte Bilderfassungseinrichtung I4 ist der der dritten Aufnahme A3 zugeordnet und ist aufstromseitig zur Klebstoff-Ausbringposition KAP angeordnet. Die vierte Bilderfassungseinrichtung I4 dient dazu, wenigstens eine der Vielzahl elektronischer Teilbaugruppen ANT auf dem zweiten Träger BM in ihrer Lage relativ zu der dritten Aufnahme A3 zu erfassen und eine die erfasste Lage repräsentierende Information an die Steuerung ECU zu signalisieren.

Eine zwölfte Fördereinrichtung F12 ist in dieser Ausgestaltung durch zwei gesteuert anzutreibende Transportwalzen gebildet, die jeweils auf- und abstromseitig zu der trommelförmigen dritten Aufnahme A3 angeordnet sind, und um die der zweite Träger BM geführt ist. In Ansprache auf von der Steuerung ECU signalisierte Information, wird der zweite Träger BM durch die zwei gesteuert anzutreibenden Transportwalzen in seiner Lage relativ zu der Klebstoff-Ausbringposition KAP so gefördert, dass die wenigstens eine der Vielzahl elektronischer Teilbaugruppen ANT mit der Klebe-Stelle KS auf dem zweiten Träger BM zu der Klebstoff-Ausbringposition KAP auf der den zweiten Träger BM führenden dritten Aufnahme A3 gelangt.

Alternativ entspricht die zwölfte Fördereinrichtung F12 der zweiten Fördereinrichtung der zweiten Aufnahme A2.

Die Klebstoff-Ausbring-Vorrichtung wirkt in der hier gezeigten Ausgestaltung mit der Übertragungs-Vorrichtung für Bauteile von einem ersten Träger zu einem zweiten Träger zusammen. Dazu ist die Vorrichtung zum Klebstoff-Ausbringen aufstromseitig zu der Übertragungs-Vorrichtung für Bauteile eingesetzt.

Bei der Vorrichtung wird die Klebe-Stelle auf dem Bahnmaterial räumlich / zeitlich vor dem eigentlichen Klebstoff-Ausbringen erfasst. Dabei erfasst eine vierte Bilderfassungseinrichtung I4 direkt, also nicht durch den zweiten Träger BM hindurch, sondern die jeweilige Klebe-Stelle KS bei der jeweiligen elektronischen Teilbaugruppe auf dem zweiten Träger BM selbst. Dann wird der zweite Träger BM so kontrolliert zu der Klebstoff-Ausbring-Position KAP gefördert, dass die Klebe-Stelle KS möglichst präzise mit der Position des Auslasses der Spendeeinrichtung SE für Klebstoff K fluchtet, wenn die Spendeeinrichtung dosiert eine Portion Klebstoff K auf die Klebe-Stelle KS ausbringt.

Die vierte Bilderfassungseinrichtung I4 ist - bezogen auf die Förderrichtung FR des zweiten Trägers BM - aufstromseitig zur Klebstoff-Ausbring-Position KAP am Umfang der trommelförmigen dritten Aufnahme A3 angeordnet und dient dazu, in Förderrichtung und/oder quer zur Förderrichtung FR des zweiten Trägers BM jeweils ein oder mehrere der Vielzahl elektronischer Teilbaugruppen ANT auf dem zweiten Träger BM in ihrer Lage relativ zu der dritten Aufnahme A3 zu erfassen und eine die erfasste Lage repräsentierende Information an die Steuerung ECU zu signalisieren.

Der zwölften Fördereinrichtung F12 ist eine zweite Sensoreinrichtung SE2 zugeordnet, um der Steuerung ECU Information zu Förderrichtung und Förderweg des zweiten Trägers BM relativ zu der Klebstoff-Ausbring-Position KAP zu signalisieren.

Die Steuerung ECU dient dazu, basierend auf der Information der vierten Bilderfassungseinrichtung I4 zur Lage der wenigstens einen elektronische Teilbaugruppe ANT und der Information zu Förderrichtung und Förderweg des zweiten Trägers BM sowie basierend auf der Information der vierten Bilderfassungseinrichtung I4 zur Lage wenigstens eines der Bauteile B relativ zur Klebstoff-Ausbring-Position KAP die elfte Fördereinrichtung F11 anzusteuern, um die Spendeeinrichtung SE quer zur Förderrichtung FR des zweiten Trägers BM zu bewegen.

Eine dreizehnte Fördereinrichtung F13, dient dazu, in Ansprache auf von der Steuerung ECU signalisierte Information, den zweiten Träger BM entlang der Förderrichtung FR über die dritte Aufnahme A3 zu fördern. Dies geschieht, durch die Steuerung ECU gesteuert, so schlupffrei und so dehnungsfrei, dass die wenigstens eine der Vielzahl elektronischer Teilbaugruppen ANT auf dem zweiten Träger BM zu der Klebstoff-Ausbring-Position KAP auf der den zweiten Träger BM führenden dritten Aufnahme A3 gelangt.

Die dritte Aufnahme A3 ist - vergleichbar zur zweiten Aufnahme A2 eine kreis-zylindrische Trommel oder eine konvex gekrümmte Fläche, über die der zweite Träger BM zu der Klebstoff-Ausbringposition KAP auf der dritten Aufnahme A3 gelangt. Auch hier hat die dritte Aufnahme an ihrer den zweiten Träger BM führenden Mantel-/Oberfläche Auslässe um den zweiten Träger BM mittels Unterdruck Vak an der dritten Aufnahme A3 schlupffrei und dehnungsfrei zu halten.

Eine fünfte Bilderfassungseinrichtung I5 ist bezogen auf die Förderrichtung FR des zweiten Trägers BM abstromseitig zur Klebstoff-Ausbring-Position KAP am Umfang der trommelförmigen dritten Aufnahme A3 angeordnet und dient dazu, wenigstens eine der Vielzahl elektronischer Teilbaugruppen ANT auf dem zweiten Träger BM und den auf sie ausgebrachten Klebstoff K in ihrer Lage relativ zu einander zu erfassen und eine die erfasste Lage repräsentierende Information an die Steuerung ECU zu signalisieren.

Eine vierzehnte Fördereinrichtung F14 dient dazu, die vierte Bilderfassungseinrichtung I4 relativ zu der dritten Aufnahme A3 und der Klebstoff-Ausbring-Position KAP zu fördern. So kann die vierte Bilderfassungseinrichtung I4 wenigstens eine Klebestelle KS auf dem zweiten Träger BM erfassen, um wenigstens eine der Vielzahl elektronischer Teilbaugruppen ANT auf dem zweiten Träger BM in ihrer Lage zu erfassen und eine die erfasste Lage repräsentierende Information an die Steuerung ECU zu signalisieren.

Eine fünfzehnte Fördereinrichtung F15 dient dazu, die fünfte Bilderfassungseinrichtung I5 relativ zu der dritten Aufnahme A3 und der Klebstoff-Ausbring-Position KAP entlang des Umfangs der dritten Aufnahme A3 und/oder quer zur Förderrichtung FR des zweiten Trägers BM zu fördern. So kann die fünfte Bilderfassungseinrichtung I5 wenigstens eine der Vielzahl elektronischer Teilbaugruppen ANT auf dem zweiten Träger BM und den auf sie ausgebrachten Klebstoff K in ihrer Lage relativ zu einander zu erfassen und eine die erfasste Lage repräsentierende Information an die Steuerung ECU zu signalisieren.

In besonders einfacher und vorteilhafter Weise ist der gemäß Fig. 2 in X-/Y-/Theta-Koordinaten verstellbare Tisch wie folgt ausgestaltet: Die den ersten Träger W aufnehmende Aufnahme A1 ist an einer ersten Trägerplatte angeordnet, wobei die fünfte Fördereinrichtung F5 dazu dient, die erste Aufnahme A1 um einen Winkel Theta relativ zur ersten Trägerplatte zu rotieren.

Die erste Trägerplatte ist an einer zweiten Trägerplatte in Quererstreckung (Y) des zweiten Trägers BM verschiebbar angeordnet. Die erste Fördereinrichtung F1 ist dazu vorgesehen, die erste Trägerplatte und somit auch die erste Aufnahme A1 (ausschließlich) quer zur Förderrichtung FR des zweiten Trägers BM relativ zu der zweiten Trägerplatte zu bewegen.

Die zweite Trägerplatte ist an einer starren, dritten Trägerplatte oder an einem Tragrahmen in Förderrichtung FR des zweiten Trägers BM verschiebbar angeordnet. Die vierte Fördereinrichtung F4 ist dazu vorgesehen, die erste Aufnahme W, die erste Trägerplatte und die zweite Trägerplatte (ausschließlich) in Förderrichtung FR des zweiten Trägers BM relativ zu der dritten Trägerplatte zu bewegen.

In Fig. 3 sind die zweiten bis fünften Bilderfassungseinrichtungen I2 ... I5 für die vorstehend beschriebenen Vorrichtungen zum Übertragen elektronischer Bauteile B von einem ersten Träger W zu einem zweiten Träger BM und zum Auftragen von Klebstoff K aus einem Vorrat auf einen zweiten Träger BM wie nachstehend beschrieben ausgestaltet.

In einer Ausgestaltung kann entweder die Bilderfassungseinrichtung BE (Kamera) bei den Bilderfassungseinrichtungen I2 ... I5 in Y-Richtung verschoben werden. In dieser Variante kann die Strahlumlenkung entfallen. Alternativ kann die restliche Optik umfassend eine Fokussieroptik, Strahlumlenkung und/oder Beleuchtung in Y-Richtung bewegt werden, während die Kamera ortsfest bleibt, und nicht in Y-Richtung bewegt wird. Bei dieser Variante wird die Kamera nur im Winkel über den Schwenkarm eingestellt wird.

Einer Bilderfassungseinrichtung BE in Gestalt einer Kamera ist eine Beleuchtungseinrichtung zugeordnet. Die Beleuchtungseinrichtung hat eine Weiß-Licht- WL, eine Rot-Licht- RLR, und eine Blau-Licht-Quelle RLB. Die Beleuchtungseinrichtung dient dazu, Licht unterschiedlicher Wellenlänge auf die zweite Aufnahme A2 zu richten. Damit können unterschiedliche Details der Bauteile / der Teilbaugruppen, des Klebers von der Bilderfassungseinrichtung BE bildlich erfasst werden, die auf den zweiten Träger BM gerichtet ist.

Eine sechzehnte, siebzehnte, achtzehnte und/oder neunzehnte Fördereinrichtung F16 ... F19 ist jeweils dazu eingerichtet, die jeweilige Bilderfassungseinrichtung BE mit der ihr zugeordneten Beleuchtungseinrichtung WL, RLB, RLB entlang der zweiten bzw. dritten Aufnahme A2 A3, sprich quer zur Förderrichtung des zweiten Trägers BM zu fördern. Mit anderen Worten sind sechzehnte, siebzehnte, achtzehnte und/oder neunzehnte Fördereinrichtung F16 ... F19 y-Antriebe, und achte, neunte, vierzehnte und/oder fünzehnte Fördereinrichtung F8, F9, F14, F15 motorische Schwenkarme vorgesehen, deren Funktion auch manuell erfüllt werden kann.

Die achte, neunte, vierzehnte, und fünfzehnte Fördereinrichtung F8, F9, F14, F15 dienen dazu, die jeweilige zweite, dritte, vierte und/oder fünfte Bilderfassungseinrichtung I2 ... I5 relativ zu der jeweilige zweiten und/oder dritten Aufnahme A2, A3 und der Bauteil-Ablageposition AP oder der Klebstoff-Ausbring-Position KAP entlang der Förderrichtung FR des zweiten Träger BM zu fördern. Dadurch kann die jeweilige zweite, dritte, vierte und/oder fünfte Bilderfassungseinrichtung I2 ... I5 vorteilhaft an unterschiedliche Abstände elektronischer Teilbaugruppen auf dem zweiten Träger angepasst werden.

In der gezeigten Variante der Beleuchtungseinrichtung WL, RLB sind die Rot-Licht-RLR, und die Blau-Licht-Quelle RLB als Ringlichtquelle ausgestaltet, die einen Erfassungsbereich EB der Bilderfassungseinrichtung BE umgeben. Die Weiß-Licht-Quelle WL ist auf einer von dem Erfassungsbereich EB der Bilderfassungseinrichtung BE abliegenden Seite einer teilweise lichtdurchlässigen Strahlumlenkung SU in Gestalt eines 45°-Spiegels angeordnet. Die Bilderfassungseinrichtung BE hat jeweils eine Fokussieroptik FO, die einen fest einstellbaren Abstand FL zur ihr zugewandten Seite einer zumindest teilweise lichtdurchlässigen Strahlumlenkung SU angeordnet ist.

Der Schutzbereich des europäischen Patents wird durch die Patentansprüche bestimmt. Die Beschreibung und die Zeichnungen sind jedoch zur Auslegung der Patentansprüche heranzuziehen.

## Patentansprüche

1. Eine Vorrichtung zum Übertragen elektronischer Bauteile (B) von einem ersten Träger (W) zu einem zweiten Träger (BM), wobei
- der erste Träger (W) eine Vielzahl vereinzelter Bauteile von ihm lösbar trägt, und
- der zweite Träger (BM) quasi-endlos ausgestaltet ist und in seiner Längserstreckung eine Vielzahl elektronischer Teilbaugruppen (ANT) trägt, zu denen jeweils eines der Bauteile von dem ersten Träger (W) zu übertragen ist, und wobei die Vorrichtung umfasst:
- eine erste Aufnahme (A1), die dazu vorgesehen und eingerichtet ist, den ersten Träger (W) aufzunehmen;
- eine zweite Aufnahme (A2), die dazu vorgesehen und eingerichtet ist, den zweiten Träger (BM) entlang seiner Längserstreckung in einer Förderrichtung des zweiten Trägers (BM) zu führen; wobei
- die erste Aufnahme (A1) dazu vorgesehen und eingerichtet ist, den ersten Träger (W) so aufzunehmen, dass die von ihm getragenen Bauteile (B) zu der zweiten Aufnahme (A2) hin orientiert sind;
- eine Trenneinrichtung (TE), die dazu vorgesehen und eingerichtet ist, die Bauteile (B) von dem ersten Träger (W) berührend oder berührungslos abzutrennen, um sie auf den zweiten Träger (BM) zu übertragen;
- die zweite Aufnahme (A2) eine in der Förderrichtung des zweiten Trägers (BM) gekrümmte Anlagefläche (AF) für den zweiten Träger (BM) aufweist, und
- der zweiten Aufnahme (A2) eine Fördereinrichtung (F3, F3', F3") für den zweiten Träger (BM) zumindest teilweise zugeordnet ist, wobei die Fördereinrichtung (F3, F3', F3") dazu vorgesehen und eingerichtet ist, in Ansprache auf von einer Steuerung signalisierte Information, den zweiten Träger (BM) in seiner Lage relativ zu einer Ablageposition (AP) so zu fördern, dass eine elektronische Teilbaugruppe (ANT) auf dem zweiten Träger (BM) zu der Ablageposition (AP) auf der den zweiten Träger (BM) führenden zweiten Aufnahme (A2) gelangt und wobei
- eine im Bereich der zweiten Aufnahme (A2) wirkende Heizung (H) angeordnet ist, die dazu vorgesehen und eingerichtet ist, den zweiten Träger (BM) vor, an oder nach der Ablageposition (AP) von seiner von der ersten Aufnahme (A1) abliegenden Seite her zu temperieren durch entsprechende Ansteuerung der Heizung (H) durch die Steuerung (ECU) einheitlich oder in Abschnitten im Bereich der zweiten Aufnahme (A2) in Abhängigkeit von der Materialbeschaffenheit, dem Schmelzpunkt von Kontaktstellen des zu übertragenden Bauteils (B) und/oder der Materialbeschaffenheit, dem Schmelzpunkt von Kontaktstellen der elektronischen Teilbaugruppe (ANT) auf dem zweiten Träger (BM), und wobei
- die Heizung (H) als Heizleiste mit einer oder mehreren unterschiedlich zu temperierenden Heizzonen ausgestaltet ist, die eine der Kontur der zweiten Aufnahme (A2) zumindest teilweise folgende Gestalt hat und die dazu vorgesehen und eingerichtet ist, den zweiten Träger (BM) im Bereich der zweiten Aufnahme (A2) zu beheizen.

2. Die Vorrichtung zum Übertragen elektronischer Bauteile (B) von einem ersten Träger (W) zu einem zweiten Träger (BM) nach Anspruch 1, wobei
- die zweite Aufnahme (A2) die Fördereinrichtung (F3, F3', F3") für den zweiten Träger (BM) zumindest teilweise umfasst, und die Fördereinrichtung (F3, F3', F3") nur einen Teil der zweiten Aufnahme (A2) quer zu der Förderrichtung des zweiten Trägers (BM) einnimmt, und/oder
- die gekrümmte Anlagefläche (AF) und/oder die Fördereinrichtung (F3, F3', F3") mit einer Unterdruckquelle (Vak) zu verbindende Öffnungen (O1) aufweist, die dazu vorgesehen und eingerichtet sind, den zweiten Träger (BM) in eine enge Anlage an die gekrümmte Anlagefläche (AF) zu bringen.

3. Die Vorrichtung zum Übertragen elektronischer Bauteile (B) von einem ersten Träger (W) zu einem zweiten Träger (BM) nach Anspruch 1 oder 2, wobei
- die gekrümmte Anlagefläche (AF) starr ist, und
- die Fördereinrichtung (F3, F3', F3") für den zweiten Träger (BM) die gekrümmte Anlagefläche (AF) entlang der Förderrichtung des zweiten Trägers (BM) in wenigstens zwei Abschnitte (AF1, AF2) unterteilt.

4. Die Vorrichtung zum Übertragen elektronischer Bauteile (B) von einem ersten Träger (W) zu einem zweiten Träger (BM) nach Anspruch 1, 2 oder 3, wobei
- die Heizung (H) dazu vorgesehen und eingerichtet ist, durch Signalisierung aus der Steuerung (ECU) eine elektrische und mechanische Verbindung bei der Ablage des Bauteils (B) auf den zweiten Träger (BM) zwischen dem Bauteil (B) und dem zweiten Träger (BM) herzustellen, indem die elektronischen Teilbaugruppen (ANT) auf dem zweiten Träger (BM) auf eine Temperatur gebracht werden, bei der Material oder Lot der elektronischen Teilbaugruppen (ANT) zumindest im Bereich freiliegender Enden der elektronischen Teilbaugruppen (ANT) auf ihre Schmelztemperatur gebracht werden, und bei der Ablage des Bauteils (B) Kontakte des Bauteils (B) damit in Berührung gebracht werden.

5. Die Vorrichtung zum Übertragen elektronischer Bauteile (B) von einem ersten Träger (W) zu einem zweiten Träger (BM) nach einem der Ansprüche 1 bis 4, wobei
- eine Wärme-Abschirmung (WA) in Förderrichtung des zweiten Trägers (BM) gesehen vor und/oder nach der Ablageposition (AP) angeordnet ist, und/oder
- zwischen der gekrümmten Anlagefläche (AF) und der Wärme-Abschirmung (WA) ein Spalt (SP) für den zweiten Träger (BM) angeordnet ist.

6. Die Vorrichtung zum Übertragen elektronischer Bauteile (B) von einem ersten Träger (W) zu einem zweiten Träger (BM) nach einem der Ansprüche 1 bis 5, wobei der Vorrichtung
aufstrom- und/oder abstromseitig der Ablageposition (AP) oder der gekrümmten Anlagefläche (AF) ein Pufferspeicher (PS) zugeordnet ist, der dazu vorgesehen und eingerichtet ist, einen Vorrat des zweiten Trägers (BM) aufzunehmen.

7. Die Vorrichtung zum Übertragen elektronischer Bauteile (B) von einem ersten Träger (W) zu einem zweiten Träger (BM) nach einem der Ansprüche 1 bis 6, bei der
- eine erste Bilderfassungseinrichtung (I1) dazu vorgesehen und eingerichtet ist, im Bereich der Ablageposition (AP) einen Bildeinzug zumindest eines an dem ersten Träger (W) befindlichen Bauteils (B) vorzunehmen und der Steuerung zu signalisieren, und/oder
- eine zweite und/oder eine dritte Bilderfassungseinrichtung (I2, I3) angeordnet, und dazu vorgesehen und eingerichtet ist, im Bereich aufstrom- und/oder abstromseitig der Ablageposition (AP) Bildeinzüge von wenigstens einer elektronischen Teilbaugruppe (ANT) auf dem zweiten Träger (BM) ohne / mit dem Bauteil (B) vorzunehmen und der Steuerung zu signalisieren.

8. Die Vorrichtung zum Übertragen elektronischer Bauteile (B) von einem ersten Träger (W) zu einem zweiten Träger (BM) nach einem der Ansprüche 1 bis 7, wobei
- ein Abstand (D) zwischen der gekrümmten Anlagefläche (AF) und der ersten Aufnahme (A1) durch eine Verstelleinrichtung einstellbar ist.

9. Die Vorrichtung zum Übertragen elektronischer Bauteile (B) von einem ersten Träger (W) zu einem zweiten Träger (BM) nach einem der Ansprüche 1 bis 8, wobei
- die gekrümmte Anlagefläche (AF) mit der Fördereinrichtung (F3, F3', F3") für den zweiten Träger (BM) im Wesentlichen senkrecht zu der Förderrichtung des zweiten Trägers (BM) beweglich geführt ist, wobei die gekrümmte Anlagefläche (AF) und/oder die wenigstens eine Fördereinrichtung (F3, F3', F3") durch eine jeweilige Stelleinrichtung in Ansprache auf von der Steuerung (ECU) signalisierte Information zu positionieren sind.

10. Die Vorrichtung zum Übertragen elektronischer Bauteile (B) von einem ersten Träger (W) zu einem zweiten Träger (BM) nach einem der Ansprüche 1 bis 9, wobei
- im Bereich aufstrom- und/oder abstromseitig der gekrümmten Anlagefläche (AF) oder der Ablageposition (AP) jeweils wenigstens ein Niederhalter (NH1, NH2) vorgesehen und eingerichtet ist, um den zweiten Träger (BM) im Bereich der gekrümmten Anlagefläche (AF) dem Unterdruck (Vak) auszusetzen.

11. Die Vorrichtung zum Übertragen elektronischer Bauteile (B) von einem ersten Träger (W) zu einem zweiten Träger (BM) nach einem der Ansprüche 1 bis 10, wobei
- die Heizung (H) eine Heizzone oder mehrere unterschiedlich zu temperierende Heizzonen aufweist, wobei
- im Bereich aufstrom- und/oder abstromseitig und/oder entlang der Quererstreckung der gekrümmten Anlagefläche (AF) oder der Ablageposition (AP) wenigstens eine Heizzone angeordnet ist, die dazu vorgesehen und eingerichtet ist, in Ansprache auf von der Steuerung (ECU) signalisierte Information Wärme abzugeben, und wobei im Fall mehrerer Heizzonen diese dazu vorgesehen und eingerichtet sind, in Ansprache auf von der Steuerung (ECU) signalisierte Information unabhängig voneinander Wärme abzugeben.

12. Die Vorrichtung zum Übertragen elektronischer Bauteile (B) von einem ersten Träger (W) zu einem zweiten Träger (BM) nach einem der Ansprüche 1 bis 11, wobei
- im Bereich aufstromseitig der Ablageposition (AP) eine dritte, vorzugsweise gekrümmte Aufnahme (A3) und ein Klebstoff-Spender (KS1) angeordnet sind, die dazu vorgesehen und eingerichtet sind, zwischen sich den zweiten Träger (BM) hindurchzuführen, und in Ansprache auf von der Steuerung signalisierte Information portioniert Klebstoff auf den zweiten Träger (BM) abzugeben.

13. Die Vorrichtung zum Übertragen elektronischer Bauteile (B) von einem ersten Träger (W) zu einem zweiten Träger (BM) nach Anspruch 12, wobei
- im Bereich aufstrom- und/oder abstromseitig der dritten Aufnahme (A3) eine vierte und/ oder eine fünfte Bilderfassungseinrichtung (I4, 15) angeordnet, und dazu vorgesehen und eingerichtet ist, im Bereich aufstrom- und/oder abstromseitig der dritten Aufnahme (A3) Bildeinzüge von wenigstens einer elektronischen Teilbaugruppe (ANT) auf dem zweiten Träger (BM) ohne / mit dem abgegebenen Klebstoff vorzunehmen und der Steuerung zu signalisieren.

14. Die Vorrichtung zum Übertragen elektronischer Bauteile (B) von einem ersten Träger (W) zu einem zweiten Träger (BM) nach einem der Ansprüche 12 bis 13, wobei
- der dritten Aufnahme (A3) eine zusätzliche Fördereinrichtung (F12, F13) zugeordnet ist, die dazu vorgesehen und eingerichtet ist, den zweiten Träger (BM) entlang der weiteren gekrümmten Anlagefläche (AF2) zu fördern.

15. Die Vorrichtung zum Übertragen elektronischer Bauteile (B) von einem ersten Träger (W) zu einem zweiten Träger (BM) nach einem der Ansprüche 1 bis 6 oder 8 bis 14, wobei
- der Trenneinrichtung (TE) eine Justiereinrichtung (JE) zugeordnet ist, die dazu vorgesehen und eingerichtet ist, die Trenneinrichtung (TE) in Förderrichtung des zweiten Trägers (BM) und/oder quer dazu zu positionieren, und/oder
- bei der Ablageposition (AP) eine erste Bilderfassungseinrichtung (I1) angeordnet, und dazu vorgesehen und eingerichtet ist, wenigstens eines der Teilbaugruppen (ANT) in ihrer Lage relativ zu einer Ablageposition (AP) auf der den zweiten Träger (BM) führenden zweiten Aufnahme (A2) zu erfassen; und/oder
- eine zweite Bilderfassungseinrichtung (I2) angeordnet, und dazu vorgesehen und eingerichtet ist, die aufstromseitig zur Ablageposition (AP) wenigstens eine der elektronischer Teilbaugruppen (ANT) auf dem zweiten Träger (BM) in ihrer Lage relativ zu der zweiten Aufnahme (A2) zu erfassen und eine die erfasste Lage repräsentierende Information an eine Steuerung zu signalisieren.

16. Ein Verfahren zum Übertragen elektronischer Bauteile (B) von einem ersten Träger (W) zu einem zweiten Träger (BM), wobei der erste Träger (W) eine Vielzahl vereinzelter Bauteile von ihm lösbar trägt, und der zweite Träger (BM) quasi-endlos ausgestaltet ist und in seiner Längserstreckung eine Vielzahl elektronischer Teilbaugruppen (ANT) trägt, zu denen in einer Ablageposition (P) jeweils eines der Bauteile von dem ersten Träger (W) zu übertragen ist, und wobei das Verfahren umfasst:
- den ersten Träger (W) mit einer ersten Aufnahme (A1) aufnehmen;
- den zweiten Träger (BM) entlang seiner Längserstreckung in einer Förderrichtung des zweiten Trägers (BM) mit einer zweiten Aufnahme (A2) führen;
- mit der ersten Aufnahme (A1) den ersten Träger (W) so aufnehmen, dass die von ihm getragenen Bauteile (B) zu der zweiten Aufnahme (A2) hin orientiert sind;
- die Bauteile (B) von dem ersten Träger (W) mit einer Trenneinrichtung (TE) berührend oder berührungslos abtrennen, um sie auf den zweiten Träger (BM) zu übertragen;
- den zweiten Träger (BM) in Ansprache auf von einer Steuerung (ECU) signalisierte Information in seiner Lage relativ zu der Ablageposition (AP) mit einer Fördereinrichtung (F3, F3', F3") für den zweiten Träger (BM) so zu fördern, dass eine elektronische Teilbaugruppe (ANT) auf dem zweiten Träger (BM) zu der Ablageposition (AP) auf der den zweiten Träger (BM) führenden zweiten Aufnahme (A2) gelangt, wobei
- im Bereich der zweiten Aufnahme (A2) eine Heizung (H) wirkt, um den zweiten Träger (BM) vor, an oder nach der Ablageposition (AP) von seiner von der ersten Aufnahme (A1) abliegenden Seite her zu temperieren durch entsprechende Ansteuerung der Heizung durch die Steuerung (ECU) einheitlich oder in Abschnitten im Bereich der zweiten Aufnahme (A2) in Abhängigkeit von der Materialbeschaffenheit, dem Schmelzpunkt von Kontaktstellen des zu übertragenden Bauteils (B) und/ oder der Materialbeschaffenheit, dem Schmelzpunkt von Kontaktstellen der elektronischen Teilbaugruppe (ANT) auf dem zweiten Träger (BM), wobei die Heizung (H) als Heizleiste mit einer oder mehreren unterschiedlich zu temperierenden Heizzonen ausgestaltet ist, die eine der Kontur der zweiten Aufnahme (A2) zumindest teilweise folgende Gestalt hat und den zweiten Träger (BM) im Bereich der zweiten Aufnahme (A2) beheizt.

## Claims

1. An apparatus for transferring electronic components (B) from a first carrier (W) to a second carrier (BM), wherein
- the first carrier (W) carries a plurality of individual components detachably therefrom, and
- the second carrier (BM) is quasi-endless and carries in its longitudinal extension a plurality of electronic subassemblies (ANT) to each of which one of the components is to be transferred from the first carrier (W), and wherein the device comprises:
- a first receptacle (A1) provided and adapted to receive said first carrier (W);
- a second receptacle (A2) provided and adapted to guide said second carrier (BM) along its longitudinal extension in a conveying direction of said second carrier (BM); wherein
- the first receptacle (A1) is provided and arranged to receive the first carrier (W) such that the components (B) carried thereby are oriented towards the second receptacle (A2);
- a separating device (TE) provided and arranged to separate the components (B) from the first carrier (W) in a contacting or non-contacting manner in order to transfer them to the second carrier (BM);
- the second receptacle (A2) has a contact surface (AF) for the second carrier (BM) which is
curved in the conveying direction of the second carrier (BM), and
- a conveying device (F3, F3', F3") for the second carrier (BM) is at least partially associated with the second receptacle (A2), wherein the conveying device (F3, F3', F3") is designed and set up to convey the second carrier (BM) in its position relative to a placement position (AP) in response to information signalled by a control unit, that an electronic subassembly (ANT) on the second carrier (BM) reaches the placement position (AP) on the second receptacle (A2) guiding the second carrier (BM), and wherein
- a heating (H) acting in the region of the second receptacle (A2) is arranged, which is provided and arranged for the purpose of tempering the second carrier (BM) before, at or after the placement position (AP) from its side remote from the first receptacle (A1) by appropriate control of the heating (H) by the control unit (ECU) as a whole or in sections in the region of the second receptacle (A2) as a function of the material properties, the melting point of contact points of the component (B) to be transferred and/or the material properties, the melting point of contact points of the electronic subassembly (ANT) on the second carrier (BM), and wherein
- the heating (H) is designed as a heating strip with one or more heating zones to be heated to different temperatures, which has a shape at least partially following the contour of the second receptacle (A2) and which is provided and set up to heat the second carrier (BM) in the region of the second receptacle (A2).

2. The apparatus for transferring electronic components (B) from a first carrier (W) to a second carrier (BM) according to claim 1, wherein
- the second receptacle (A2) comprises the conveying device (F3, F3', F3") for the second carrier (BM) at least partially, and the conveying device (F3, F3', F3") occupies only a part of the second receptacle (A2) transverse to the conveying direction of the second carrier (BM), and/or
- the curved contact surface (AF) and/or the conveying device (F3, F3', F3") have openings (O1) to be connected to an underpressure source (Vak), which openings (O1) are provided and adapted to bring the second carrier (BM) into close abutment with the curved contact surface (AF).

3. The apparatus for transferring electronic components (B) from a first carrier (W) to a second carrier (BM) according to claim 1 or 2, wherein
- the curved contact surface (AF) is rigid, and
- the conveying device (F3, F3', F3") for the second carrier (BM) divides the curved contact surface (AF) along the conveying direction of the second carrier (BM) into at least two sections (AF1, AF2).

4. The apparatus for transferring electronic components (B) from a first carrier (W) to a second carrier (BM) according to claim 1, 2 or 3, wherein
- the heating (H) is provided and arranged to establish an electrical and mechanical connection between the component (B) and the second carrier (BM) by signaling from the control unit (ECU) when the component (B) is deposited on the second carrier (BM) by bringing the electronic subassemblies (ANT) on the second carrier (BM) to a temperature, at which material of the electronic subassembly (ANT) or solder - are brought to their melting temperature at least in the region of exposed ends of the electronic subassembly (ANT), and contacts of the component (B) are brought into contact therewith when the component part (B) is deposited.

5. The apparatus for transferring electronic components (B) from a first carrier (W) to a second carrier (BM) according to any one of claims 1 to 4, wherein
- a heat shield (WA) is arranged upstream and/or downstream of the placement position (AP), as viewed in the conveying direction of the second carrier (BM),
and/or
- a gap (SP) for the second carrier (BM) is arranged between the curved contact surface (AF) and the heat shield (WA).

6. The apparatus for transferring electronic components (B) from a first carrier (W) to a second carrier (BM) according to one of claims 1 to 5, wherein a buffer store (PS) is associated with the device on the upstream and/or downstream side of the placement position (AP) or the curved contact surface (AF), which buffer store (PS) is provided and set up to receive a supply of the second carrier (BM).

7. The apparatus for transferring electronic components (B) from a first carrier (W) to a second carrier (BM) according to one of claims 1 to 6, in which
- a first image acquisition device (I1) is provided and set up to carry out an image acquisition of at least one component (B) located on the first carrier (W) in the region of the placement position (AP) and to signal this to the control unit, and/or
- a second and/or a third image acquisition device (I2, I3) is arranged, and is provided and set up for this purpose to carry out image acquisitions of at least one electronic subassembly (ANT) on the second carrier (BM) without/with the component (B) in the region on the upstream and/or downstream side of the placement position (AP) and to signal this to the control unit.

8. The apparatus for transferring electronic components (B) from a first carrier (W) to a second carrier (BM) according to any one of claims 1 to 7, wherein
- a distance (D) between the curved contact surface (AF) and the first receptacle (A1) is adjustable by an adjusting device.

9. The apparatus for transferring electronic components (B) from a first carrier (W) to a second carrier (BM) according to one of claims 1 to 8, wherein
- the curved contact surface (AF) with the conveying device (F3, F3', F3") for the second carrier (BM) is movably guided essentially perpendicular to the conveying direction of the second carrier (BM), wherein the curved contact surface (AF) and/or the at least one conveying device (F3, F3', F3") are to be positioned by a respective actuating device in response to information signaled by the control unit (ECU).

10. The apparatus for transferring electronic components (B) from a first carrier (W) to a second carrier (BM) according to one of claims 1 to 9, wherein
- in the region on the upstream and/or downstream side of the curved contact surface (AF) or the placement position (AP), at least one hold-down device (NH1, NH2) is provided in each case and inserted in order to subject the second carrier (BM) to the negative pressure (Vak) in the region of the curved contact surface (AF).

11. The apparatus for transferring electronic components (B) from a first carrier (W) to a second carrier (BM) according to any one of claims 1 to 10, wherein
- the heating (H) has a heating zone or a plurality of heating zones to be heated to different temperatures, wherein
- in the region on the upstream and/or downstream side and/or along the transverse extension of the curved contact surface (AF) or the placement position (AP) at least one heating zone is arranged, which is provided and set up to emit heat in response to information signalled by the control unit (ECU), and wherein in the case of a plurality of heating zones these are provided and set up to emit heat independently of one another in response to information signalled by the control unit (ECU).

12. The apparatus for transferring electronic components (B) from a first carrier (W) to a second carrier (BM) according to one of claims 1 to 11, wherein
- in the region upstream of the placement position (AP) a third, curved, receptacle (A3) and an adhesive dispenser (KS1) are arranged, which are provided and set up for passing the second carrier (BM) between them and for dispensing adhesive in portions onto the second carrier (BM) in response to information signalled by the - control unit.

13. The apparatus for transferring electronic components (B) from a first carrier (W) to a second carrier (BM) according to claim 12, wherein- a fourth and/or a fifth image acquisition device (I4, I5) is arranged in the region upstream and/or downstream of the third receptacle (A3), and for this purpose and a is directed to carry out image captures of at least one electronic subassembly (ANT) on the second carrier (BM) without/with the dispensed adhesive in the region on the upstream and/or downstream side of the third receptacle (A3) and to signal it to the control unit.

14. The apparatus for transferring electronic components (B) from a first carrier (W) to a second carrier (BM) according to any one of claims 12 to 13, wherein- an additional conveying device (F12, F13) is associated with the third receptacle (A3), which conveying device (F12, F13) is provided and set up to convey the second carrier (BM) along the further curved contact surface (AF2).

15. The apparatus for transferring electronic components (B) from a first carrier (W) to a second carrier (BM) according to one of claims 1 to 6 or 8 to 14, wherein
- the separating device (TE) is assigned an adjusting device (JE) which is provided and set up for positioning the separating device (TE) in the conveying direction of the second carrier (BM) and/or transversely thereto, and/or
- a first image acquisition device (I1) is arranged at the placement position (AP) and is provided and arranged to capture at least one of the subassemblies (ANT) in its position relative to a placement position (AP) on the second pick-up (A2) guiding the second carrier (BM); and/or
a second image acquisition device (I2) is arranged and is provided and set up to capture the position of at least one of the electronic subassemblies (ANT) on the second carrier (BM) relative to the second receptacle (A2) on the upstream side of the placement position (AP) and to signal information representing the captured position to a control unit.

16. A method for transferring electronic components (B) from a first carrier (W) to a second carrier (BM), wherein the first carrier (W) detachably carries a plurality of individual components therefrom, and the second carrier (BM) is quasi-endless and carries in its longitudinal extension a plurality of electronic subassemblies (ANT) to each of which one of the components is to be transferred from the first carrier (W) in a placement position (P), and wherein the method comprises:
- receiving the first carrier (W) with a first receptacle (A1);
- guiding the second carrier (BM) along its longitudinal extension in a conveying direction of the second carrier (BM) with a second receptacle (A2);
- receive the first carrier (W) with the first receptacle (A1) in such a way that the components (B) carried by it are oriented towards the second receptacle (A2);
- separate the components (B) from the first carrier (W) with a separating device (TE) in a contacting or contactless manner in order to transfer them to the second carrier (BM);
- conveying the second carrier (BM) in response to information signalled by a control unit in its position relative to the placement position (AP) by means of a conveying device (F3, F3', F3") for the second carrier (BM) in such a way that an electronic subassembly (ANT) on the second carrier (BM) reaches the placement position (AP) on the second receptacle (A2) guiding the second carrier (BM), wherein
- a heating (H) acts in the region of the second receptacle (A2) in order to temper the second carrier (BM) before, at or after the placement position (AP) from its side remote from the first receptacle (A1) by appropriate control of the heating by the control unit (ECU) uniformly or in sections in the region of the second receptacle (A2) as a function of the material properties, the melting point of contact points of the component (B) to be transferred and/or the material properties, the melting point of contact points of the electronic subassembly (ANT) on the second carrier (BM), the heating (H) being designed as a heating strip with one or more heating zones to be heated to different temperatures, which heating strip has a shape at least partially following the contour of the second receptacle (A2) and heats the second carrier (BM) in the region of the second receptacle (A2).

## Revendications

1. Un dispositif pour transférer des composants électroniques (B) d'un premier support (W) à un deuxième support (BM), dans lequel
- le premier support (W) porte de manière amovible une pluralité de composants individuels, et
- le deuxième support (BM) est conçu de manière quasi-continue et porte dans son extension longitudinale une pluralité de sous-ensembles électroniques (ANT), dans chacun desquels un des composants doit être transféré du premier support (W), et dans lequel le dispositif comprend:
- un premier réceptacle (A1) prévu et agencé pour recevoir le premier support (W);
- un deuxième réceptacle (A2) prévu et agencé pour guider le deuxième support (BM) le long de son extension longitudinale dans une direction de transport du deuxième support (BM); dans lequel
- le premier logement (A1) est prévu et agencé pour recevoir le premier support (W) de telle sorte que les composants (B) qu'il porte soient orientés vers le deuxième logement (A2) ;
- un dispositif de séparation (TE) prévu et agencé pour séparer les composants (B) du premier support (W) avec ou sans contact, afin de les transférer sur le deuxième support (BM) ;
- le deuxième logement (A2) présente une surface d'appui (AF) pour le deuxième support (BM), courbée dans la direction de transport du deuxième support (BM), et
- un dispositif de transport (F3, F3', F3") pour le deuxième support (BM) est associé au moins partiellement au deuxième logement (A2), le dispositif de transport (F3, F3', F3") étant prévu et agencé pour, en réponse à une information signalée par une commande, de transporter le deuxième support (BM) dans sa position par rapport à une position de dépose (AP) de telle sorte qu'un sous-ensemble électronique (ANT) sur le deuxième support (BM) parvienne à la position de dépose (AP) sur le deuxième logement (A2) guidant le deuxième support (BM) et dans lequel
- un chauffage (H) agissant dans la zone du deuxième logement (A2) est disposé, lequel est prévu et agencé pour chauffer le deuxième support (BM) avant, à ou après la position de dépose (AP) depuis son côté éloigné du premier logement (A1) par une commande correspondante du chauffage (H) par la commande (ECU) de manière uniforme ou par sections dans la zone du deuxième logement (A2) en fonction de la nature du matériau, du point de fusion des points de contact du composant à transférer (B) et/ou de la nature du matériau, du point de fusion de points de contact du sous-ensemble électronique (ANT) sur le deuxième support (BM), et dans lequel
- le chauffage (H) est conçu comme une barrette chauffante avec une ou plusieurs zones de chauffage à tempérer différemment, qui a une forme suivant au moins partiellement le contour du deuxième logement (A2) et qui est prévue et aménagée pour chauffer le deuxième support (BM) dans la zone du deuxième logement (A2).

2. Le dispositif de transfert de composants électroniques (B) d'un premier support (W) à un deuxième support (BM) selon la revendication 1, dans lequel
- le deuxième logement (A2) comprend au moins partiellement le dispositif de transport (F3, F3', F3") pour le deuxième support (BM), et le dispositif de transport (F3, F3', F3") n'occupe qu'une partie du deuxième logement (A2) transversalement à la direction de transport du deuxième support (BM), et/ou
- la surface d'appui incurvée (AF) et/ou le dispositif de transport (F3, F3', F3") présentent des ouvertures (O1) à relier à une source de dépression (Vak), qui sont prévues et agencées pour amener le deuxième support (BM) en appui étroit contre la surface d'appui incurvée (AF).

3. Le dispositif pour transférer des composants électroniques (B) d'un premier support (W) à un deuxième support (BM) selon la revendication 1 ou 2, dans lequel
- la surface d'appui courbe (AF) est rigide, et
- le dispositif de transport (F3, F3', F3") pour le deuxième support (BM) divise la surface d'appui courbe (AF) le long de la direction de transport du deuxième support (BM) en au moins deux sections (AF1, AF2).

4. Le dispositif pour transférer des composants électroniques (B) d'un premier support (W) à un deuxième support (BM) selon la revendication 1, 2 ou 3, dans lequel
- le chauffage (H) est prévu et agencé pour établir, par signalisation à partir de la commande (ECU), une liaison électrique et mécanique lors de la dépose du composant (B) sur le deuxième support (BM) entre le composant (B) et le deuxième support (BM), en amenant les sous-ensembles électroniques (ANT) sur le deuxième support (BM) à une température à laquelle le matériau ou la soudure des sous-ensembles électroniques (ANT) sont amenés à leur température de fusion au moins dans la zone des extrémités exposées des sous-ensembles électroniques (ANT), et en mettant en contact des contacts du composant (B) avec ceux-ci lors de la dépose du composant (B).

5. Le dispositif de transfert de composants électroniques (B) d'un premier support (W) à un deuxième support (BM) selon l'une des revendications 1 à 4, dans lequel
- un écran thermique (WA) est disposé, vu dans le sens de transport du deuxième support (BM), en amont et/ou en aval de la position de dépose (AP), et/ou
- un interstice (SP) pour le deuxième support (BM) est disposé entre la surface d'appui incurvée (AF) et l'écran thermique (WA).

6. Le dispositif de transfert de composants électroniques (B) d'un premier support (W) vers un second support (BM) selon l'une des revendications 1 à 5, le dispositif étant est associé, en amont et/ou en aval de la position de dépôt (AP) ou de la surface d'appui courbe (AF), à une mémoire tampon (PS) prévue et agencée pour recevoir une réserve du deuxième support (BM).

7. Le dispositif de transfert de composants électroniques (B) d'un premier support (W) à un deuxième support (BM) selon l'une des revendications 1 à 6, dans lequel
- un premier dispositif d'acquisition d'image (I1) est prévu et agencé pour effectuer , dans la zone de la position de dépose (AP), une prise d'image d'au moins un composant (B) se trouvant sur le premier support (W) et pour la signaler à la commande, et/ou
- un deuxième et/ou un troisième dispositif d'acquisition d'images (I2, I3) est disposé, et est prévu et équipé pour effectuer, dans la zone en amont et/ou en aval de la position de dépose (AP), des prises d'images d'au moins un sous-ensemble électronique (ANT) sur le deuxième support (BM) sans / avec le composant (B) et pour les signaler à la commande.

8. Le dispositif de transfert de composants électroniques (B) d'un premier support (W) à un deuxième support (BM) selon l'une des revendications 1 à 7, dans lequel
- une distance (D) entre la surface d'appui incurvée (AF) et le premier logement (A1) est réglable par un dispositif de réglage.

9. Le dispositif de transfert de composants électroniques (B) d'un premier support (W) à un deuxième support (BM) selon l'une des revendications 1 à 8, dans lequel
- la surface d'appui incurvée (AF) avec le dispositif de transport (F3, F3', F3") pour le deuxième support (BM) est guidée de manière mobile essentiellement perpendiculairement à la direction de transport du deuxième support (BM), la surface d'appui incurvée (AF) et/ou le au moins un dispositif de transport (F3, F3', F3") devant être positionnés par un dispositif de réglage respectif en réponse à des informations signalées par la commande (ECU).

10. Le dispositif de transfert de composants électroniques (B) d'un premier support (W) à un deuxième support (BM) selon l'une des revendications 1 à 9, dans lequel
- dans la zone en amont et/ou en aval de la surface d'appui courbe (AF) ou de la position de dépôt (AP), au moins un serre-flan (NH1, NH2) est respectivement prévu et aménagé pour exposer le deuxième support (BM) à la dépression (Vak) dans la zone de la surface d'appui courbe (AF).

11. Le dispositif de transfert de composants électroniques (B) d'un premier support (W) à un deuxième support (BM) selon l'une des revendications 1 à 10, dans lequel
- le chauffage (H) présente une zone de chauffage ou plusieurs zones de chauffage à tempérer différemment, au moins une zone de chauffage étant disposée dans la région en amont et/ou en aval et/ou le long de l'extension transversale de la surface d'appui incurvée (AF) ou de la position de dépose (AP), laquelle est prévue et agencée pour délivrer de la chaleur en réponse à une information signalée par la commande (ECU), et dans le cas de plusieurs zones de chauffage, celles-ci étant prévues et agencées pour délivrer de la chaleur indépendamment les unes des autres en réponse à une information signalée par la commande (ECU).

12. Le dispositif de transfert de composants électroniques (B) d'un premier support (W) à un deuxième support (BM) selon l'une des revendications 1 à 11, dans lequel
- dans la zone en amont de la position de dépôt (AP) sont disposés un troisième logement (A3), de préférence incurvé, et un distributeur de colle (KS1), qui sont prévus et agencés pour faire passer entre eux le deuxième support (BM), et pour délivrer de la colle en portions sur le deuxième support (BM) en réponse à une information signalée par la commande.

13. Le dispositif de transfert de composants électroniques (B) d'un premier support (W) à un deuxième support (BM) selon la revendication 12, dans lequel
- un quatrième et/ou un cinquième dispositif d'acquisition d'images (I4, I5) est disposé dans la zone en amont et/ou en aval du troisième logement (A3), et est prévu et agencé pour effectuer, dans la zone en amont et/ou en aval du troisième logement (A3), des tirages d'images d'au moins un sous-ensemble électronique (ANT) sur le deuxième support (BM) sans / avec la colle délivrée et pour les signaler à la commande.

14. Le dispositif de transfert de composants électroniques (B) d'un premier support (W) à un deuxième support (BM) selon l'une des revendications 12 à 13, dans lequel
- au troisième logement (A3) est associé un dispositif de transport supplémentaire (F12, F13) qui est prévu et agencé pour transporter le deuxième support (BM) le long de l'autre surface d'appui incurvée (AF2).

15. Le dispositif de transfert de composants électroniques (B) d'un premier support (W) vers un deuxième support (BM) selon l'une des revendications 1 à 6 ou 8 à 14, dans lequel
- au dispositif de séparation (TE) est associé un dispositif d'ajustement (JE) prévu et agencé pour positionner le dispositif de séparation (TE) dans la direction de transport du deuxième support (BM) et/ou transversalement à celle-ci, et/ou
- un premier dispositif de détection d'images (I1) est disposé à la position de dépose (AP), et est prévu et aménagé pour détecter au moins un des sous-ensembles (ANT) dans sa position par rapport à une position de dépose (AP) sur le deuxième logement (A2) guidant le deuxième support (BM) ; et/ou
- un deuxième dispositif de détection d'images (I2) est disposé, et est prévu et aménagé pour détecter la position en amont de la position de dépôt (AP) d'au moins l'un des sous-ensembles électroniques (ANT) sur le deuxième support (BM) par rapport au deuxième logement (A2) et pour signaler à une commande une information représentant la position détectée.

16. Procédé de transfert de composants électroniques (B) d'un premier support (W) à un second support (BM), le premier support (W) portant de manière amovible une pluralité de composants individuels et le second support (BM) étant quasi-continu et portant dans sa longueur une pluralité de sous-ensembles électroniques (ANT) vers chacun desquels l'un des composants doit être transféré depuis le premier support (W) dans une position de dépôt (P), le procédé comprenant :
- recevoir le premier support (W) avec un premier réceptacle (A1) ;
- guider le deuxième support (BM) le long de son extension longitudinale dans une direction de transport du deuxième support (BM) avec un deuxième réceptacle (A2) ;
- recevoir avec le premier logement (A1) le premier support (W) de telle sorte que les composants (B) qu'il porte soient orientés vers le deuxième logement (A2) ;
- séparer les composants (B) du premier support (W) avec un dispositif de séparation (TE), avec ou sans contact, pour les transférer sur le deuxième support (BM) ;
- faire avancer le deuxième support (BM), en réponse à des informations signalées par une commande (ECU), dans sa position par rapport à la position de dépose (AP) avec un dispositif de transport (F3, F3', F3") pour le deuxième support (BM), de telle sorte qu'un sous-ensemble électronique (ANT) arrive sur le deuxième support (BM) à la position de dépose (AP) sur le deuxième logement (A2) guidant le deuxième support (BM), dans lequel
- un chauffage (H) agit dans la zone du deuxième logement (A2) pour faire avancer le deuxième support (BM) avant, à ou après la position de dépose (AP) à partir de son côté opposé au premier logement (A1) par une commande correspondante du chauffage par la commande (ECU) de manière uniforme ou par sections dans la zone du deuxième logement (A2) en fonction de la nature du matériau, du point de fusion des points de contact du composant à transférer (B) et/ou de la nature du matériau, du point de fusion de points de contact du sous-ensemble électronique (ANT) sur le deuxième support (BM), le chauffage (H) étant conçu comme une barrette chauffante avec une ou plusieurs zones chauffantes à tempérer différemment, qui a une forme suivant au moins partiellement le contour du deuxième logement (A2) et qui chauffe le deuxième support (BM) dans la zone du deuxième logement (A2).
